# EUROPEAN PATENT APPLICATION

(11) **EP 4 658 007 A1**
(43) Date of publication of application: **03.12.2025**
(21) Application number: 24777437.5
(22) Date of filing: 15.01.2024
(51) Int. Cl.: H05K 7/20

(54) **COMMUNICATION SINGLE BOARD AND COMMUNICATION DEVICE**

(30) Priority: 24.03.2023 CN 202320621018 U
(71) Applicant: Huawei Technologies Co., Ltd., Shenzhen, Guangdong 518129 (CN)
(72) Inventor: SUN, Xiangquan, Shenzhen, Guangdong 518129 (CN); LIU, Chaorong, Shenzhen, Guangdong 518129 (CN); NIE, Cong, Shenzhen, Guangdong 518129 (CN); ZHENG, Guangming, Shenzhen, Guangdong 518129 (CN); LIU, Chaowu, Shenzhen, Guangdong 518129 (CN)
(74) Representative: Gill Jennings & Every LLP
(86) International application number: PCT/CN2024/072235
(87) International publication number: WO 2024/198642

(57) **Abstract**

This application provides a communication board and a communication device. A housing of the communication board has a mounting cavity. A first trigger component is mounted in the housing. During insertion and removal of the communication board in a slot, the first trigger component can move relative to the housing, and a transmission component can move relative to the housing when being driven by the first trigger component. A backflow prevention component is connected to the transmission component. A backflow prevention plate disposed on an outer side of the housing can rotate relative to the housing when being driven by the transmission component, to switch between a closed state and an open state. When the backflow prevention plate is in the open state, the backflow prevention plate is open relative to a side wall of the housing, and an included angle between the backflow prevention plate and the side wall of the housing is an acute angle at which an opening faces a bottom portion of the housing. In the communication board provided in this application, the operation of the backflow prevention plate is not affected by a back-flowing air force, resulting in strong applicability. In this way, a problem that back-flowing air affects heat dissipation of the communication device can be better resolved, and components in the communication board operate smoothly.

## Description

This application claims priority to Chinese Patent Application No. 202320621018.8, filed with the China National Intellectual Property Administration on March 24, 2023 and entitled "COMMUNICATION BOARD AND COMMUNICATION DEVICE", which is incorporated herein by reference in its entirety.

### TECHNICAL FIELD

This application relates to the field of communication device technologies, and in particular, to a communication board and a communication device.

### BACKGROUND

There are a plurality of slots in a chassis of a communication device, and a communication board is disposed in each slot. The communication board in operation generates heat, and a heat dissipation apparatus is disposed in the chassis. In a wind cooling system of an ICT (Information and Communications Technology, information and communications technology) fixed network product, when a communication board is to be maintained or replaced, the communication board needs to be removed from a slot, providing a vacant slot in a communication device. The vacant slot forms an air channel. Most air for heat dissipation of the communication device flows back through the air channel, affecting heat dissipation of a system chip, and further causing a system operation failure. In an existing solution, a backflow prevention plate is disposed on a side of a communication board, where the backflow prevention plate is rotatably connected to a housing of the communication board. When a communication board is removed from a slot, a backflow prevention plate on a communication board in a neighboring slot of the slot opens automatically and seals the vacant slot, avoiding formation of an air backflow channel. In this way, a problem that back-flowing air affects heat dissipation of a system is resolved.

However, in the conventional technology, an included angle between the open backflow prevention plate and the housing of the communication board faces a top portion of the housing, and back-flowing air flows from a bottom portion to the top portion of the housing. The back-flowing air generates pressure on the backflow prevention plate, and in this case, the backflow prevention plate tends to rotate in a closed direction. Therefore, a rotatable connection structure between the backflow prevention plate and the housing needs to generate sufficient resistance to an air force. When the resistance of the rotatable connection structure cannot resist the pressure of the back-flowing air, the backflow prevention plate rotates in the closed direction. As a result, the vacant slot cannot be completely sealed, and a backflow prevention gap is increasingly large as a back-flowing air force increases (where a gap between an open backflow prevention plate of a communication board and a side wall of a communication board in a spaced slot is referred to as the backflow prevention gap). Consequently, a large volume of back-flowing air enters the communication device through the backflow prevention gap. Therefore, as a back-flowing air force increases, a rotatable connection structure with higher resistance needs to be designed to resist the back-flowing air force. This results in low applicability of the communication board. The rotatable connection structure needs to be redesigned and the structure of the communication board needs to be adjusted each time the system is upgraded. In addition, increasing the resistance of the rotatable connection structure also brings a series of problems.

For example, in the conventional technology, a rotatable connection between a backflow prevention plate and a housing of a communication board is implemented by using a torsion spring. As a back-flowing air force increases, a torsion spring with a higher torsion spring force needs to be designed to resist the back-flowing air force. When the backflow prevention plate rotates, a friction force between the torsion spring and a rotating shaft needs to be overcome. The increase of the torsion spring force requires the increase of a length of the torsion spring, and the friction force between the torsion spring and the rotating shaft also increases correspondingly, reducing the smoothness of rotation of the backflow prevention plate. Consequently, the backflow prevention plate does not open in place, and other problems also occur, resulting in an excessively large backflow prevention gap.

According to another aspect, as the resistance of the rotatable connection structure increases, a trigger component in the communication board also needs to generate a higher trigger force to drive the backflow prevention plate to open. The trigger component in operation deforms due to a tensile force. As a requirement for the trigger force by the system increases, the tensile force on the trigger component increases, exacerbating the deformation. In addition, when the trigger component moves, there is a friction force between the trigger component and the housing of the communication board. As the trigger force increases, the friction force also increases continuously, and finally a dead point of the friction force is reached (when a friction force between two components that move relative to each other increases to a value, the two components are relatively stuck and cannot continue to move regardless of how much force is applied, where a stuck contact point is referred to as the dead point of the friction force). As a result, the trigger component cannot operate smoothly. Although the friction force can be reduced by reducing a friction coefficient between the trigger component and the housing, a limit of an engineering capability of the friction coefficient has been reached in the conventional technology, and consequently this problem still cannot be resolved.

It can be learned that, in the conventional technology, an operation of the backflow prevention plate of the communication board is affected by the back-flowing air force, resulting in low applicability of the communication board and unsmooth system operation, and the backflow prevention gap becomes larger as the back-flowing air force increases, affecting heat dissipation performance of the communication device.

### SUMMARY

Embodiments of this application provide a communication board and a communication device, resolving conventional-technology problems that an operation of a backflow prevention plate of the communication board is affected by a back-flowing air force, resulting in low applicability of the communication board and unsmooth system operation, and a backflow prevention gap becomes larger as the back-flowing air force increases, affecting heat dissipation performance of the communication device.

An embodiment of this application provides a communication board for a communication device. The communication board is disposed in a slot of the communication device in a pluggable manner, and includes a housing, a first trigger component, a transmission component, and a backflow prevention component.

The housing has a top portion and a bottom portion that are opposite to each other, and a side wall connected between the top portion and the bottom portion, and a mounting cavity is surrounded by the top portion, the bottom portion, and the side wall of the housing.

The first trigger component is mounted in the housing, and at least a partial structure is disposed in the mounting cavity; and the first trigger component is movable relative to the housing during insertion and removal of the communication board in the slot, for the first trigger component to switch between a trigger position and a non-trigger position relative to the housing.

The transmission component is mounted in the mounting cavity and is connected to the first trigger component, and the transmission component is movable relative to the housing in a first direction when being driven by the first trigger component, for the transmission component to switch between a first position and a second position relative to the housing.

The backflow prevention component is connected to the transmission component and is located on a side that is of the first trigger component and that is away from the bottom portion of the housing. The backflow prevention component includes a backflow prevention plate disposed on an outer side of the housing, and the backflow prevention plate is rotatable relative to the housing when being driven by the transmission component, for the backflow prevention plate to switch between a closed state and an open state.

When the backflow prevention plate is in the closed state, the backflow prevention plate is attached to the side wall of the housing, and the transmission component is located at the first position. When the backflow prevention plate is in the open state, the backflow prevention plate is open relative to the side wall of the housing, an included angle between the backflow prevention plate and the side wall of the housing is an acute angle at which an opening faces the bottom portion of the housing, and the transmission component is located at the second position.

In addition, when the first trigger component is located at the non-trigger position, the transmission component is located at the first position, and the backflow prevention plate is in the closed state; and when the first trigger component switches from the non-trigger position to the trigger position, the transmission component is movable from the first position to the second position when being driven by the first trigger component, to drive the backflow prevention plate to move from the closed state to the open state.

According to the communication board provided in this application, the backflow prevention plate can switch between the open state and the closed state. The backflow prevention plate in the open state may be configured to seal a neighboring vacant slot in the communication device. In addition, the acute angle facing the bottom portion of the housing is formed between the backflow prevention plate and the side wall of the housing of the communication board, and back-flowing air in the communication device usually flows from the bottom portion of the housing to the top portion of the housing, that is, flows directly toward the opening between the backflow prevention plate and the side wall of the housing. Therefore, pressure of the back-flowing air on the backflow prevention plate causes the backflow prevention plate to have a tendency to move in an open direction instead of a closed direction, thereby avoiding a phenomenon that the backflow prevention gap becomes larger due to the backflow prevention plate closed under an action of a back-flowing air force. This better resolves a problem that the back-flowing air affects heat dissipation of the communication device. Moreover, the design of a rotatable connection structure between the backflow prevention plate and the housing is decoupled from the magnitude of the back-flowing air force, thereby improving applicability of the communication board.

According to another aspect, because the rotatable connection structure between the backflow prevention plate and the housing does not need to be designed based on an air force, the magnitude of a trigger force of the trigger component is also decoupled from the air force. Therefore, a phenomenon that the trigger component in operation deforms due to a large tensile force can be reduced, and a problem that a dead point of a friction force is reached due to a large friction force between the trigger component and the housing is avoided, improving smoothness of system operation, and reducing a risk of getting stuck.

Therefore, in the communication board provided in this application, the operation of the backflow prevention plate is not affected by a back-flowing air force, and the backflow prevention gap does not become larger with the increase of the air force, resulting in strong applicability of the communication board. In this way, a problem that back-flowing air affects heat dissipation of the communication device can be better resolved, and components in the communication board operate smoothly.

In some embodiments, when the backflow prevention plate is in the open state, the backflow prevention plate can seal a slot adjacent to the communication board, to prevent back-flowing air from entering the communication device through the vacant slot.

In some embodiments, an end that is of the backflow prevention plate and that is close to the top portion of the housing is rotatably connected to the housing around a first axis, where the first axis is perpendicular to the first direction. When the backflow prevention plate switches from the closed state to the open state, the transmission component is movable, toward the bottom portion of the housing in the first direction, from the first position to the second position, and drives the backflow prevention plate to rotate around the first axis in a direction away from the side wall of the housing, for the backflow prevention plate to move to the open state. The entire backflow prevention plate can open relative to the side wall of the housing, resulting in high rotation efficiency.

In some embodiments, the communication board further includes a second trigger component, and the second trigger component is connected to the transmission component and includes a second trigger rod disposed on the outer side of the housing. The second trigger rod is rotatable relative to the housing and drives the transmission component to move in the first direction, for the backflow prevention plate to switch between the open state and the closed state.

Based on this structure, when the communication board is located in the slot, the second trigger component can trigger the backflow prevention plate to return to the closed state from the open state.

In some embodiments, an end that is of the second trigger rod and that is close to the bottom portion of the housing is rotatably connected to the housing around a second axis, and the second trigger rod and the backflow prevention plate are movable toward each other or opposite to each other through movement of the transmission component in the first direction, where the second axis is perpendicular to the first direction.

When the backflow prevention plate is in the closed state, the second trigger rod is attached to the side wall of the housing. When the backflow prevention plate is in the open state, the second trigger rod is open relative to the side wall of the housing, and an included angle between the second trigger rod and the side wall of the housing is an acute angle at which an opening faces the top portion of the housing. When the second trigger rod that is open relative to the side wall of the housing rotates around the second axis in a direction close to the side wall of the housing, the transmission component is movable from the second position to the first position, to drive the backflow prevention plate to move from the open state to the closed state.

Based on this structure, the transmission component, the second trigger component, and the backflow prevention component are linked to each other. The movement of the transmission component in the first direction can drive the second trigger rod and the backflow prevention plate to simultaneously open or close. The open or closed backflow prevention plate can drive, by the transmission component, the second trigger rod to simultaneously open or close. The open or closed second trigger rod can also drive, by the transmission component, the backflow prevention plate to simultaneously open or close. Therefore, when any communication board is inserted into a slot, a backflow prevention plate of a neighboring communication board can be driven to automatically close.

In some embodiments, the first trigger component and the transmission component are elastically connected by a first elastic component, for the first trigger component and the transmission component to move relative to each other in the first direction. When the first trigger component is located at the non-trigger position and the transmission component is located at the first position, or when the first trigger component is located at the trigger position and the transmission component is located at the second position, the transmission component and the first trigger component abut against each other; and when the first trigger component is located at the trigger position and the transmission component is located at the first position, the transmission component and the first trigger component are separated from each other.

Under an action of an elastic force of the first elastic component, the transmission component is capable of remaining at a position at which the transmission component and the first trigger component abut against each other, or is capable of returning, from a position at which the transmission component and the first trigger component are separated from each other, to a position at which the transmission component and the first trigger component abut against each other.

Based on this structure, in a case that a neighboring slot is a vacant slot, during insertion of a communication board in the vacant slot, the transmission component, when being driven by the first elastic component, remains in a state in which the transmission component and the first trigger component abut against each other. In this case, when the first trigger component moves from the non-trigger position to the trigger position, the transmission component is driven to move from the first position to the second position, and remains at the second position. When the communication board is located in the slot and the backflow prevention plate is in the open state, another communication board is inserted into a neighboring vacant slot, and the second trigger rod of the communication board rotates in a closed direction under an action of an external force of the inserted communication board, to drive the transmission component to move toward the first position. In this case, the transmission component overcomes a tensile force of the first elastic component to be separated from the first trigger component.

In some embodiments, an end that is of the transmission component and that is close to the top portion of the housing is elastically connected to the housing by a second elastic component, and the first trigger component is elastically connected to the housing by a third elastic component.

Under a combined action of an elastic force of the second elastic component and an elastic force of the third elastic component, the first trigger component is capable of remaining at the non-trigger position and the transmission component remains at the first position, or the first trigger component is capable of returning to the non-trigger position from the trigger position and the transmission component returns to the first position from the second position. Under a combined action of the elastic force of the first elastic component and the elastic force of the second elastic component, the transmission component is capable of remaining at a position at which the transmission component and the first trigger component abut against each other, or is capable of returning, from a position at which the transmission component and the first trigger component are separated from each other, to a position at which the transmission component and the first trigger component abut against each other.

In some embodiments, the first trigger component includes a first trigger rod and a connecting component, an opening for the first trigger rod to extend out is provided on the housing, the first trigger rod is slidably connected to the housing, a first trigger portion is disposed at an end that extends out of the mounting cavity, and in a process of inserting the communication board into the slot, the first trigger portion is configured to abut against a structural component or another communication board on the communication device, to drive the first trigger rod to move relative to the housing from the non-trigger position to the trigger position.

One end of the connecting component is detachably fastened to the first trigger rod, and the other end is capable of abutting against or is separable from the transmission component; and one end of the first elastic component is connected to the transmission component, and the other end is connected to the connecting component, for the connecting component fastened to the first trigger rod to be elastically connected to the transmission component by the first elastic component. The first trigger component and the transmission component are detachable from each other, facilitating component of the communication device.

In some embodiments, the transmission component includes a rack that extends in the first direction, the backflow prevention component further includes a first gear disposed at an end that is of the backflow prevention plate and that is close to the top portion of the housing, and the rack is engaged with the first gear.

In some embodiments, when the communication board includes the second trigger component, the second trigger component further includes a second gear disposed at an end that is of the second trigger rod and that is away from the top portion of the housing, and a third gear located between the second gear and the rack, where the third gear is engaged with the rack, and the second gear is engaged with the third gear.

In some embodiments, the backflow prevention plate is rotatably connected to the first gear, and when the backflow prevention plate is in the open state, the backflow prevention plate is rotatable, under an action of an external force in a direction toward the top portion of the housing, relative to the first gear in a direction away from the side wall of the housing.

Based on this structure, back-flowing air provides help. This can not only ensure that spaced communication boards are not stuck during insertion and removal, but also minimize the backflow prevention gap.

In some embodiments, the backflow prevention plate is rotatably connected to the first gear by a torsion spring.

In some embodiments, a flexible component is disposed at an end that is of the backflow prevention plate and that is away from the top portion of the housing. Under the action of a back-flowing air force, the flexible component can extend in a direction facing away from the side wall of the housing, to fill the backflow prevention gap.

In some embodiments, an end that is of the backflow prevention plate and that is away from the top portion of the housing is at least partially bent toward the side wall of the housing, and when the backflow prevention plate is in the open state, the end that is of the backflow prevention plate and that is away from the top portion of the housing may be located in the slot adjacent to the communication board.

Based on this structure, a bending point of the open backflow prevention plate can abut against a communication board in a spaced slot, the backflow prevention gap is reduced to 0, and stucking during insertion of spaced communication boards can be avoided.

An embodiment of this application further provides a communication device, including a chassis and a plurality of communication boards provided in any one of the foregoing embodiments, where a plurality of slots are provided on the chassis, the plurality of slots and the plurality of communication boards are in a one-to-one correspondence, each of the plurality of communication boards is disposed in the corresponding slot in a pluggable manner, and the backflow prevention plate on the communication board may be configured to seal the slot adjacent to the communication board in the communication device.

In some embodiments, after any one of the plurality of communication boards is removed from the slot, a backflow prevention plate of the communication board is in the closed state, and a backflow prevention plate of a communication board adjacent to the communication board in the communication device is switchable from the closed state to the open state.

### BRIEF DESCRIPTION OF DRAWINGS

FIG. 1 is a diagram of a three-dimensional structure of a communication device according to an embodiment of this application;
FIG. 2 is a diagram of a three-dimensional structure of a communication board and a chassis in a communication device according to an embodiment of this application;
FIG. 3a is a diagram of a principle of a communication device according to an embodiment of this application, where the communication device is in a state in which all slots are occupied;
FIG. 3b is a diagram of a principle of a communication device according to an embodiment of this application, where there is a vacant slot in the communication device;
FIG. 4a and FIG. 4b are diagrams of a principle of a communication board;
FIG. 4c is a diagram of a principle of mounting the communication board in FIG. 4a and FIG. 4b in a communication device, where there is a vacant slot in the communication device;
FIG. 5a is a diagram of a principle of a communication board according to an embodiment of this application, where a backflow prevention plate is in a closed state;
FIG. 5b is a diagram of a principle of a communication board according to an embodiment of this application, where a backflow prevention plate is in an open state;
FIG. 5c is a diagram of a principle of mounting a communication board according to an embodiment of this application in a communication device, where there is a vacant slot in the communication device;
FIG. 6a is a diagram of a process of insertion and removal of a communication board C in the case of one vacant slot in a communication device according to an embodiment of this application;
FIG. 6b is a diagram of a process of insertion and removal of a communication board C in the case of two vacant slots in a communication device according to an embodiment of this application;
FIG. 6c is a diagram of a process of insertion and removal of a communication board B in the case of two vacant slots in a communication device according to an embodiment of this application;
FIG. 7a is a diagram of a three-dimensional structure of a communication board according to an embodiment of this application, where a backflow prevention plate is in a closed state;
FIG. 7b is a diagram of a three-dimensional structure of a communication board according to an embodiment of this application, where a backflow prevention plate is in an open state;
FIG. 7c is a diagram of a three-dimensional structure of a communication board from another angle according to an embodiment of this application, where a backflow prevention plate is in a closed state;
FIG. 7d is a diagram of a three-dimensional structure of a communication board from another angle according to an embodiment of this application, where a backflow prevention plate is in an open state;
FIG. 8a is a diagram of an exploded structure of a communication board according to an embodiment of this application;
FIG. 8b is a partially enlarged view of a part E in FIG. 8a;
FIG. 9 is a diagram of a planar structure of a communication board according to an embodiment of this application, where a first trigger component is at a non-trigger position, a transmission component is at a first position, and a backflow prevention plate is in a closed state;
FIG. 10 is a diagram of a planar structure of a communication board according to an embodiment of this application, where a first trigger component is at a trigger position, a transmission component is at a second position, and a backflow prevention plate is in an open state;
FIG. 11 is a diagram of a fitting relationship between the communication board in FIG. 10 and a neighboring slot;
FIG. 12 is a diagram of a fitting relationship between a communication device and a trigger component in a communication board according to an embodiment of this application;
FIG. 13 is a diagram of a planar structure of a communication board according to an embodiment of this application, where a first trigger component is at a trigger position, a transmission component is at a first position, and a backflow prevention plate is in a closed state;
FIG. 14a and FIG. 14b are diagrams of a fitting relationship between the communication board in FIG. 13 and a communication board in a neighboring slot;
FIG. 15 is a diagram of a structure of a communication board according to an embodiment of this application, where a backflow prevention plate is rotatably connected to a first gear;
FIG. 16a is a diagram of connections of a backflow prevention plate, a torsion spring, and a first gear in a communication board according to an embodiment of this application;
FIG. 16b is a partially enlarged view of a part F in FIG. 16a;
FIG. 17 is a diagram of a principle of a communication board according to an embodiment of this application, where a flexible component is disposed at an end that is of a backflow prevention plate and that is away from a top portion of a housing;
FIG. 18 is a diagram of a planar structure of a communication board according to an embodiment of this application, where a flexible component is disposed at an end that is of a backflow prevention plate and that is away from a top portion of a housing;
FIG. 19a and FIG. 19b are diagrams of a principle of a communication board according to an embodiment of this application, where an end that is of a backflow prevention plate and that is away from a top portion of a housing is bent toward a side wall of the housing; and
FIG. 20 is a diagram of a planar structure of a communication board according to an embodiment of this application, where an end that is of a backflow prevention plate and that is away from a top portion of a housing is bent toward a side wall of the housing.

### Reference numerals:

Conventional technology:
   200': communication board;
   20': housing; 20a': top portion; 20b': bottom portion; 20c': side wall;
   21': backflow prevention plate;
   α': included angle; d': backflow prevention gap.
This application:
   100: communication device;
   1: chassis; 11: slot; 110: vacant slot;
   12: heat dissipation apparatus; 121: fan;
   13: line board; 14: mold strip;
   200: communication board;
   20: housing; 20a: top portion; 20b: bottom portion; 20c: side wall;
   21: opening; 22: base; 23: component component;
   3: first trigger component; 31: first trigger rod; 311: hook;
   32: first trigger portion; 33: connecting component; 330: cavity; 331: hook;
   4: transmission component; 41: rack;
   5: backflow prevention component; 51: backflow prevention plate;
   52: first gear; 53: torsion spring; 54: connecting plate; 55: flexible component; 56: first connecting shaft;
   6: second trigger component; 61: second trigger rod;
   62: second gear; 63: third gear; 64: second connecting shaft;
   71: first elastic component; 72: second elastic component; 73: third elastic component;
   8: mounting cavity;
   α1: included angle; α2: included angle; d: backflow prevention gap;
   x: first direction; y: second direction; o: first axis; m: second axis
   11: length direction of a communication board; l2: width direction of a communication board; l3: thickness direction of a communication board.

### DESCRIPTION OF EMBODIMENTS

The following describes implementations of this application by using specific embodiments. A person skilled in the art may easily learn of other advantages and effects of this application based on content disclosed in this specification. Although this application is described with reference to some embodiments, it does not mean that features of this application are limited only to this implementation. On the contrary, a purpose of describing this application with reference to an implementation is to cover another option or modification that may be derived based on claims of this application. To provide an in-depth understanding of this application, the following descriptions include a plurality of specific details. This application may be alternatively implemented without using these details. In addition, to avoid confusion or blurring a focus of this application, some specific details are omitted from the description. It should be noted that embodiments in this application and features in embodiments may be mutually combined in the case of no conflict.

It should be noted that, in this specification, similar reference numerals and letters in the following accompanying drawings represent similar items. Therefore, once an item is defined in an accompanying drawing, the item does not need to be further defined or interpreted in following accompanying drawings.

In descriptions of this application, it should be noted that orientation or position relationships indicated by terms "center", "above", "below", "left", "right", "vertical", "horizontal", "inner", "outer", and the like are orientation or position relationships based on the accompanying drawings, and are merely intended for conveniently describing this application and simplifying descriptions, rather than indicating or implying that an apparatus or element in question needs to have a specific orientation or needs to be constructed and operated in a specific orientation, and therefore cannot be construed as a limitation on this application. In addition, terms "first" and "second" are merely used for a purpose of description, and shall not be understood as an indication or implication of relative importance.

In descriptions of this application, it should be noted that, unless otherwise expressly specified and limited, terms "mount", "interconnect", and "connect" should be understood in a broad sense. For example, the terms may indicate a fixed connection, a detachable connection, or an integral connection; or may indicate a mechanical connection or an electrical connection; or may indicate direct interconnection, indirect interconnection through an intermediate medium, or communication between interiors of two elements. A person of ordinary skill in the art may understand specific meanings of the foregoing terms in this application according to specific cases.

In descriptions of this application, it should be understood that, in this application, an "electrical connection" may be understood as physical contact and electrical conduction of components, or may be understood as a form in which different components in a circuit structure are connected through a physical line that can transmit an electrical signal, such as printed circuit board (printed circuit board, PCB) copper foil or a conducting wire.

In descriptions of this application, it should be noted that mutual perpendicularity in this application is not absolute perpendicularity, and approximate perpendicularity (for example, an included angle between two structural features is 89.9°) caused by a machining error and an assembly error is also in a range of mutual perpendicularity in this application. Mutual parallelism in this application is not absolute parallelism either, and approximate parallelism (for example, an included angle between two structural features is 0.1°) caused by a machining error and an assembly error is also in a range of mutual parallelism in this application. This is not specifically limited in this application.

To make objectives, technical solutions, and advantages of this application clearer, the following further describes implementations of this application in detail with reference to the accompanying drawings.

A communication device (ICD for short, with a full name of Industrial Communication Device) includes a wired communication device and a wireless communication device that are used in an industrial control environment, may be used in an enterprise, a campus, Network Cloud Engine-Switch, a router, and the like, and usually includes a chassis and a plurality of communication boards disposed in the chassis. A plurality of communication components are disposed on the communication board, so that a communication function can be implemented. The communication board in operation generates heat. Therefore, a heat dissipation apparatus needs to be further provided in the chassis to dissipate heat from a chip of the communication board, to prevent an excessively high system temperature from affecting a service life of a communication element. In a wind cooling system of an ICT (Information and Communications Technology, information and communications technology) fixed network product, when a communication board is to be maintained or replaced, the communication board needs to be removed from a slot, providing a vacant slot in a communication device. The vacant slot forms an air channel. In this case, some air for heat dissipation of the communication device flows back, affecting heat dissipation of a system. Currently, a heat dissipation problem of a communication device in a system maintenance scenario has become the key to competitiveness of a communication system. The following specifically describes a structure of a communication device, a principle of formation of an air backflow channel, and a solution to the conventional technology with reference to the accompanying drawings. The structure of the communication device is merely an example, and is not limited to the following solutions during actual application.

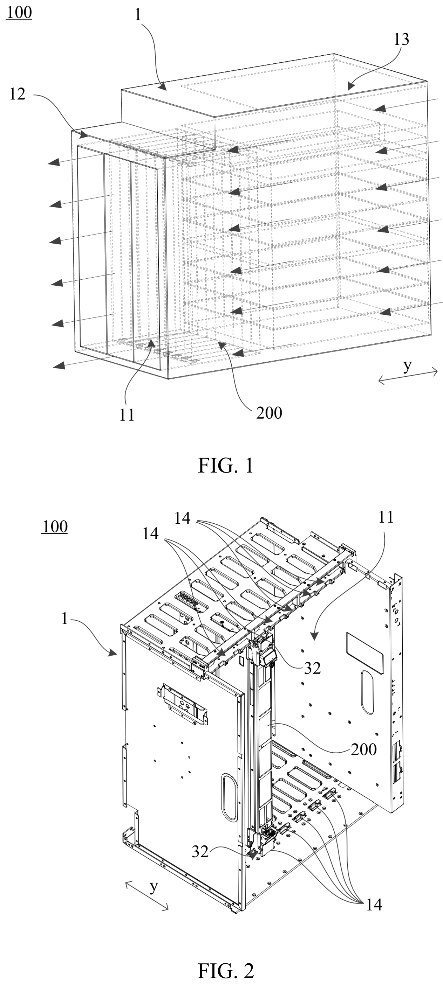

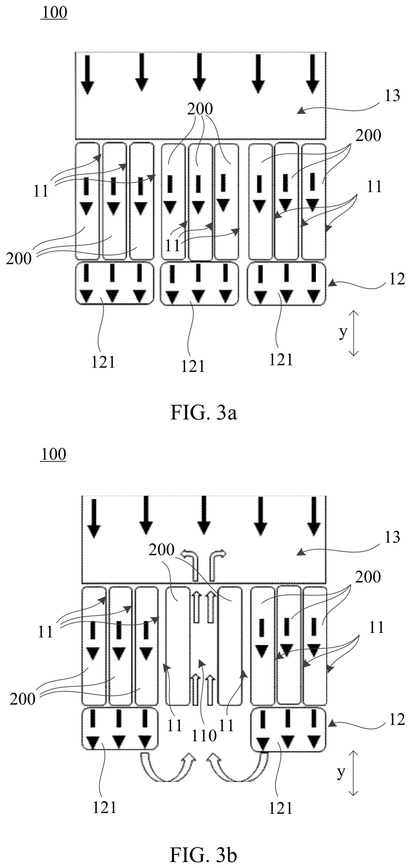

Refer to FIG. 1 to FIG. 3b. FIG. 1 is a diagram of a three-dimensional structure of a communication device according to an embodiment of this application. FIG. 2 is a diagram of a three-dimensional structure of a communication board and a chassis in a communication device according to an embodiment of this application. FIG. 3a is a diagram of a principle of a communication device according to an embodiment of this application, where the communication device is in a state in which all slots are occupied. FIG. 3b is a diagram of a principle of a communication device according to an embodiment of this application, where there is a vacant slot in the communication device.

As shown in FIG. 1 to FIG. 3b, a communication device 100 includes a chassis 1 and a plurality of communication boards 200, where a plurality of slots 11 are provided on the chassis 1, the plurality of slots 11 and the plurality of communication boards 200 are in a one-to-one correspondence, and each of the plurality of communication boards 200 is disposed in the corresponding slot 11 in a pluggable manner.

In an implementation, a plurality of line boards 13 are further mounted in the chassis 1, and the communication board 200 and the line board 13 can implement different functional modules. A manner of mounting the line board 13 in the chassis 1 is not limited. For example, a plurality of line board slots corresponding to the plurality of line boards 13 may be provided in the chassis 1, and each line board 13 is mounted in the corresponding line board slot. Alternatively, another structure may be used. This is not limited in this application.

The communication board 200 in operation generates heat. To dissipate heat from the communication device 100 and avoid heat accumulation, a heat dissipation apparatus 12 is disposed in the chassis 1. The heat dissipation apparatus 12 may be an air drawing system, an air blowing system, or the like. This is not limited in this application. In an implementation, the heat dissipation apparatus 12 is an air drawing system and includes a plurality of groups of fans 121.

Quantities of the communication boards 200, the line boards 13, and the fans 121 in the heat dissipation apparatus 12, and a layout manner of various structures in the communication device 100 are not limited. As shown in FIG. 3a and FIG. 3b, in an example, the communication device 100 includes 16 line boards 13, nine communication boards 200, and three groups of fans 121. In addition, the 16 line boards 13, the nine communication boards 200, and the heat dissipation apparatus 12 are sequentially arranged in a second direction y, and every three communication boards 200 correspond to one group of fans 121.

As shown in solid arrow directions in FIG. 1 and black arrow directions in FIG. 3a and FIG. 3b, air for heat dissipation of the communication device 100 flows through the plurality of line boards 13 and the plurality of communication boards 200 sequentially in the second direction y, and finally is blown out from each group of fans 121.

As shown in FIG. 3b, when a communication board 200 needs to be repaired or replaced, one group of fans 121 corresponding to the communication board 200 is first removed, and then the communication board 200 is removed from a slot 11 in which the communication board 200 is located. In this case, a vacant slot 110 is formed in the communication device 100, the vacant slot 110 forms an air backflow channel, and air blown from the other two groups of fans 121 reversely flows through the vacant slot 110 back into the communication device 100. For details, refer to white arrow directions in FIG. 3b.

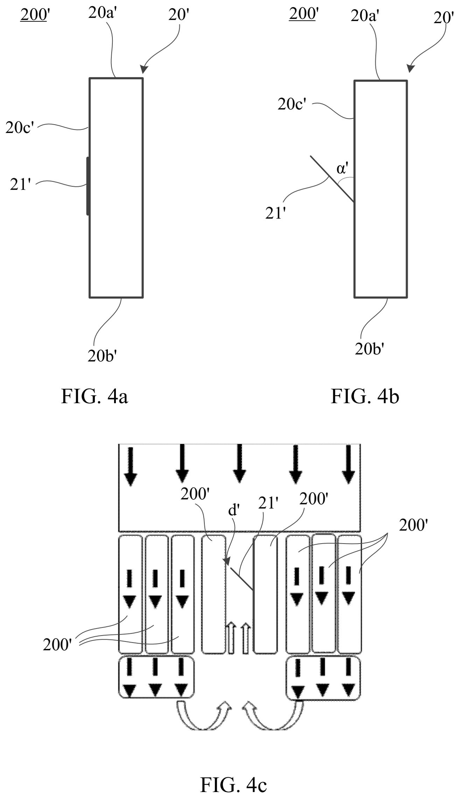

To resolve this problem, a commonly used solution is that a backflow prevention plate is disposed on a side of the communication board 200. When a communication board 200 is removed from a slot 11, a backflow prevention plate on a communication board 200 in a neighboring slot 11 opens automatically and seals the vacant slot 110. However, due to some structural defects, it is difficult for the backflow prevention plate on the communication board 200 to completely seal the neighboring vacant slot 110, resulting in poor backflow prevention effect. The following gives the reason with reference to a structure of a communication board 200' shown in FIG. 4a to FIG. 4c.

Refer to FIG. 4a to FIG. 4c. FIG. 4a and FIG. 4b are diagrams of a principle of a communication board. FIG. 4c is a diagram of a principle of mounting the communication board in FIG. 4a and FIG. 4b in a communication device, where there is a vacant slot in the communication device.

As shown in FIG. 4a to FIG. 4c, the communication board 200' includes a housing 20' and a backflow prevention plate 21'. The backflow prevention plate 21' is located on an outer side of the housing 20' and is rotatably connected to the housing 20' by a rotatable connection structure. When a communication board 200' in the communication device is removed to form a vacant slot, a backflow prevention plate 21' on a communication board 200' adjacent to the vacant slot opens relative to a housing 20', and an included angle α' is formed between the backflow prevention plate 21' and a side wall 20c' of the housing 20'.

However, the included angle α' between the backflow prevention plate 21' and the side wall 20c' of the housing 20' faces a top portion 20a' of the housing 20', and back-flowing air in the vacant slot flows from a bottom portion 20b' (the bottom portion 20b' may be a portion on which a trigger component is disposed in the housing 20') to the top portion 20a' of the housing 20'. The back-flowing air generates pressure on the backflow prevention plate 21', and in this case, the backflow prevention plate 21' tends to rotate in a closed direction. Therefore, the rotatable connection structure between the backflow prevention plate 21' and the housing 20' needs to generate sufficient resistance to an air force. When the resistance of the rotatable connection structure cannot resist the pressure of the back-flowing air, the backflow prevention plate 21' rotates in the closed direction. As a result, the vacant slot cannot be completely sealed, and a backflow prevention gap d' is increasingly large as a back-flowing air force increases (where a gap between an open backflow prevention plate of a communication board and a side wall of a communication board in a spaced slot is referred to as the backflow prevention gap). Consequently, a large volume of back-flowing air enters the communication device through the backflow prevention gap d'. Therefore, as a back-flowing air force increases, a rotatable connection structure with higher resistance needs to be designed to resist the back-flowing air force. This results in low applicability of the communication board 200'. The rotatable connection structure needs to be redesigned and the structure of the communication board 200' needs to be adjusted each time the system is upgraded. In addition, increasing the resistance of the rotatable connection structure also brings a series of problems.

For example, in the conventional technology, a rotatable connection between a backflow prevention plate 21' and a housing 20' of a communication board 200' is implemented by using a torsion spring. As a back-flowing air force increases, a torsion spring with a higher torsion spring force needs to be designed to resist the back-flowing air force. When the backflow prevention plate 21' rotates, a friction force between the torsion spring and a rotating shaft needs to be overcome. The increase of the torsion spring force requires the increase of a length of the torsion spring, and the friction force between the torsion spring and the rotating shaft also increases correspondingly, reducing the smoothness of rotation of the backflow prevention plate 21'. Consequently, the backflow prevention plate 21' does not open in place, and other problems also occur, resulting in an excessively large backflow prevention gap d'.

According to another aspect, as the resistance of the rotatable connection structure increases, a trigger component in the communication board 200' also needs to generate a higher trigger force to drive the backflow prevention plate 21' to open. The trigger component in operation deforms due to a tensile force. As a requirement for the trigger force by the system increases, the tensile force on the trigger component increases, exacerbating the deformation. In addition, when the trigger component moves, there is a friction force between the trigger component and the housing 20' of the communication board 200'. As the trigger force increases, the friction force also increases continuously, and finally a dead point of the friction force is reached (when a friction force between two components that move relative to each other increases to a value, the two components are relatively stuck and cannot continue to move regardless of how much force is applied, where a stuck contact point is referred to as the dead point of the friction force). As a result, the trigger component cannot operate smoothly. Although the friction force can be reduced by reducing a friction coefficient between the trigger component and the housing 20', a limit of an engineering capability of the friction coefficient has been reached in the conventional technology, and consequently this problem still cannot be resolved.

It can be learned that the operation of the backflow prevention plate 21' of the communication board 200' is affected by the back-flowing air force, resulting in low applicability of the communication board 200' and unsmooth system operation, and the backflow prevention gap d' becomes larger as the back-flowing air force increases, affecting heat dissipation performance of the communication device.

In view of this, an embodiment of this application provides a communication board that can better resolve a problem that back-flowing air affects heat dissipation of a communication device.

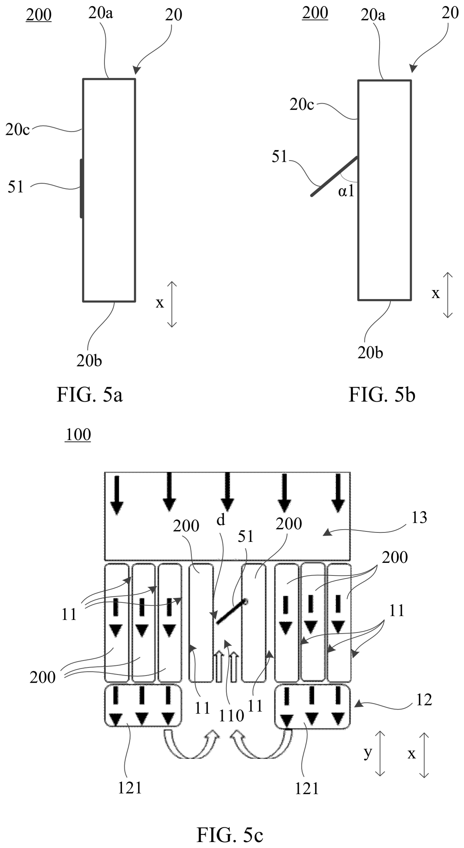

Refer to FIG. 5a to FIG. 5c. FIG. 5a is a diagram of a principle of a communication board according to an embodiment of this application, where a backflow prevention plate is in a closed state. FIG. 5b is a diagram of a principle of a communication board according to an embodiment of this application, where a backflow prevention plate is in an open state. FIG. 5c is a diagram of a principle of mounting a communication board according to an embodiment of this application in a communication device, where there is a vacant slot in the communication device.

As shown in FIG. 5a to FIG. 5c, in the communication board 200 provided in this application, a backflow prevention plate 51 is rotatably connected to a housing 20. When a communication board 200 in the communication device 100 is removed to form a vacant slot 110, a backflow prevention plate 51 on a communication board 200 adjacent to the vacant slot 110 automatically opens relative to a housing 20, and an included angle α1 is formed between the backflow prevention plate 51 and a side wall 20c of the housing 20. The included angle α1 is an acute angle at which an opening faces a bottom portion 20b of the housing 20. Therefore, back-flowing air flows directly toward the opening between the backflow prevention plate 51 and the side wall 20c of the housing 20. Pressure of the back-flowing air on the backflow prevention plate 51 causes the backflow prevention plate 51 to have a tendency to move in an open direction instead of a closed direction, thereby avoiding a phenomenon that the backflow prevention gap d becomes larger due to the backflow prevention plate 51 closed under an action of a back-flowing air force. This better resolves a problem that the back-flowing air affects heat dissipation of the communication device 100. The design of a rotatable connection structure between the backflow prevention plate 51 and the housing 20 is decoupled from the magnitude of the back-flowing air force. In this way, applicability of the communication board 200 is improved, and components in the communication board 200 operate smoothly.

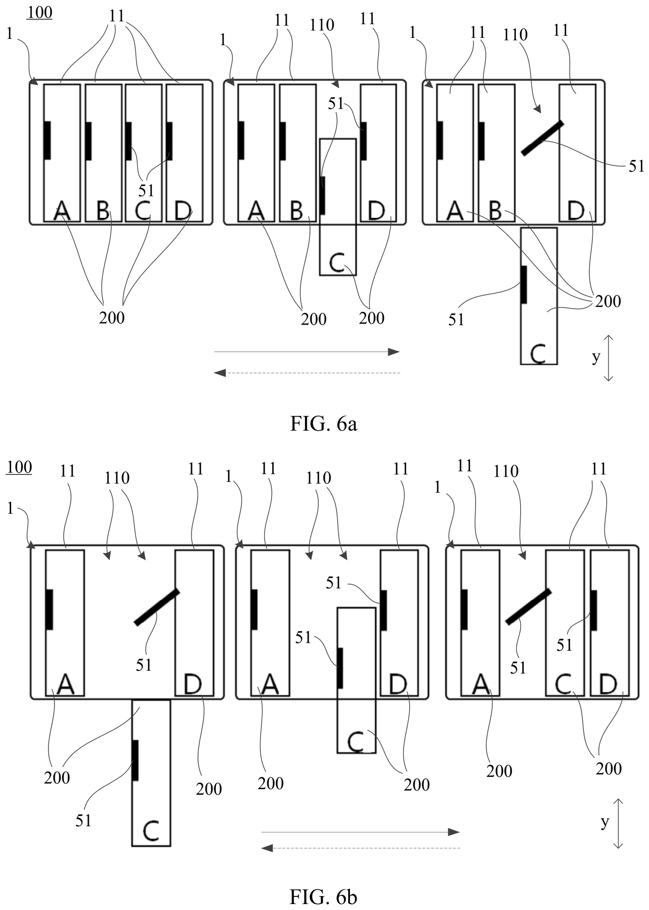

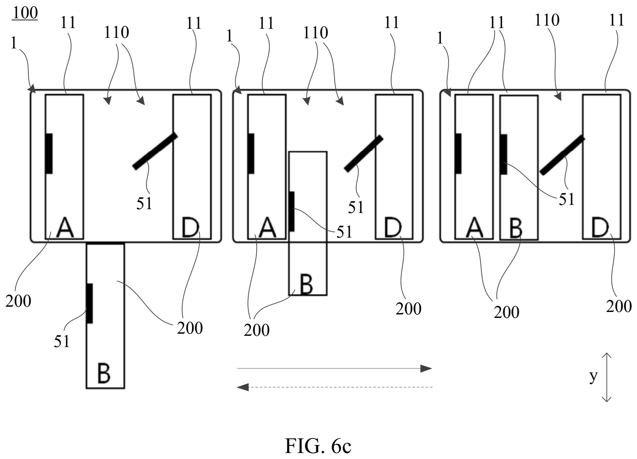

Refer to FIG. 6a to FIG. 6c. FIG. 6a is a diagram of a process of insertion and removal of a communication board C in the case of one vacant slot in a communication device according to an embodiment of this application. FIG. 6b is a diagram of a process of insertion and removal of a communication board C in the case of two vacant slots in a communication device according to an embodiment of this application. FIG. 6c is a diagram of a process of insertion and removal of a communication board B in the case of two vacant slots in a communication device according to an embodiment of this application.

As shown in FIG. 6a to FIG. 6c, the communication board 200 provided according to an embodiment of this application is disposed in a slot 11 of the communication device 100 in a pluggable manner. There are a plurality of manners of insertion and removal of the communication board 200 in the slot 11. This is not limited in this application. In addition, a direction in which the communication board 200 is inserted or pulled is not limited. For example, the communication board 200 may be inserted or pulled in the second direction y, or may be inserted or pulled in a direction perpendicular to the second direction y. In an implementation, the communication board 200 is inserted into or removed from the slot 11 of the communication device 100 in the second direction y.

In FIG. 6a to FIG. 6c, four communication boards are used as an example to describe an operation process of the communication board 200 provided in this application in the communication device 100. The four communication boards are respectively a communication board A, a communication board B, a communication board C, and a communication board D.

Refer to a process from left to right in FIG. 6a. In an implementation, when the communication device 100 is in a state in which all slots are occupied, backflow prevention plates 51 of all the communication boards 200 are all in a closed state under an action of an external force from a neighboring communication board 200 or an inner wall of a chassis 1. In this case, when the communication board C is removed from the slot 11, because the external force acting on the backflow prevention plate 51 of the communication board D disappears, the backflow prevention plate 51 of the communication board D opens automatically and then seal a vacant slot 110 corresponding to the communication board C, to prevent back-flowing air from flowing back through the vacant slot 110. In addition, after the communication board C is removed from the slot 11, the backflow prevention plate 51 of the communication board C remains in a closed state, to avoid affecting insertion and removal experience.

On the contrary, refer to a process from right to left in FIG. 6a. When the communication board C is inserted into the vacant slot 110, the backflow prevention plate 51 of the communication board C may be in a closed state under an action of an external force applied by the communication board B, and the backflow prevention plate 51 of the communication board D may close automatically under an action of an external force applied by the communication board C.

Refer to a process from left to right in FIG. 6b. In an implementation, there are two vacant slots 110 between the communication board A and the communication board D, and the backflow prevention plate 51 of the communication board D opens relative to the housing 20, to seal the vacant slot 110 that is formed correspondingly after the communication board C is removed. In this case, the communication board C is inserted into the vacant slot 110 on a left side of the communication board D, the backflow prevention plate 51 of the communication board D may close automatically under an action of an external force applied by the communication board C, and the backflow prevention plate 51 of the communication board C may open automatically relative to the housing 20, to seal the vacant slot 110 on a left side of the communication board C.

On the contrary, refer to a process from right to left in FIG. 6b. When the communication board C is removed from the slot 11, because the external force acting on the backflow prevention plate 51 of the communication board D disappears, the backflow prevention plate 51 of the communication board D may automatically return to an open state from a closed state, to seal the vacant slot 110 formed after the communication board C is removed.

Refer to a process from left to right in FIG. 6c. In an implementation, there are two vacant slots 110 between the communication board A and the communication board D, and the backflow prevention plate 51 of the communication board D opens relative to the housing 20, to seal the vacant slot 110 on the left side. In this case, when the communication board B is inserted into the vacant slot 110 on a right side of the communication board A, the communication board B can smoothly enter the slot without touching the backflow prevention plate 51 of the communication board D, and the backflow prevention plate 51 of the communication board B remains closed under an action of an external force applied by the communication board A.

It should be noted that the foregoing operation process is merely an example, and is not limited to the foregoing several cases during actual application. In addition, in embodiments of this application, there may be a plurality of structures to meet the foregoing several cases. The following describes in detail a specific structure of the communication board 200 provided in embodiments of this application with reference to the accompanying drawings.

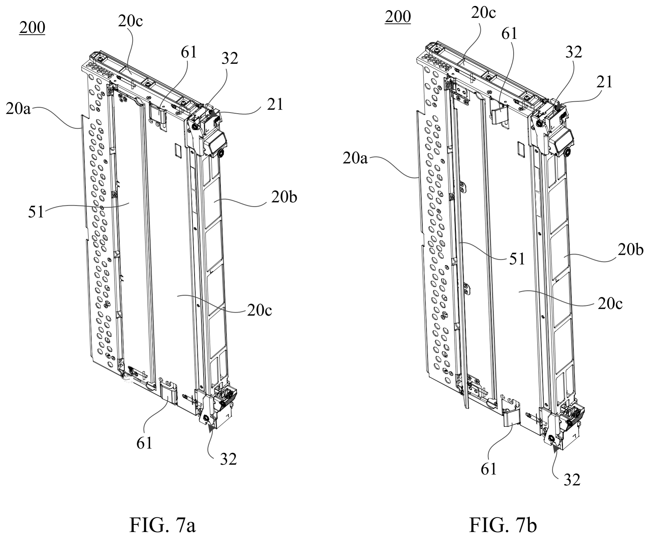

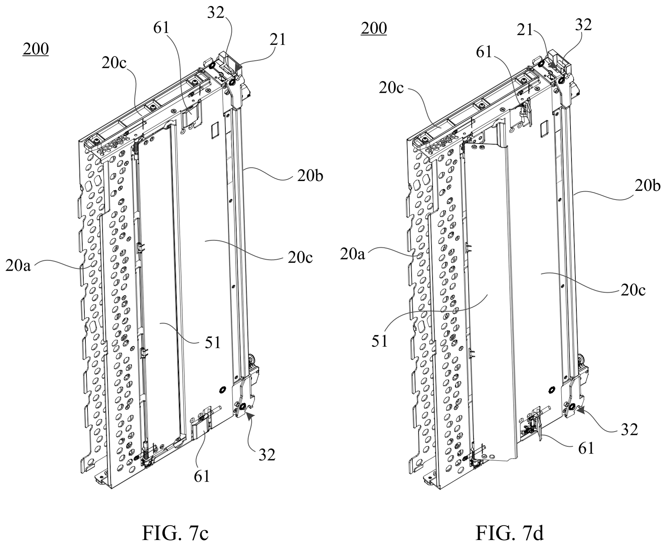

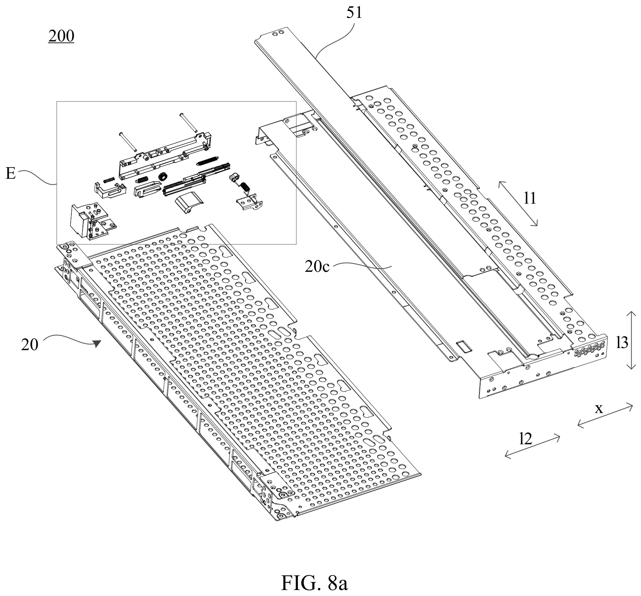

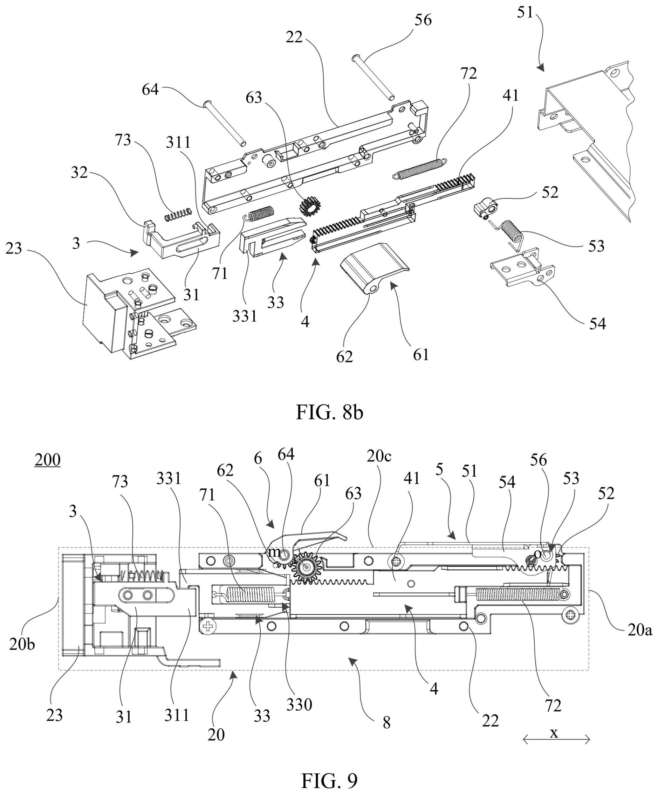

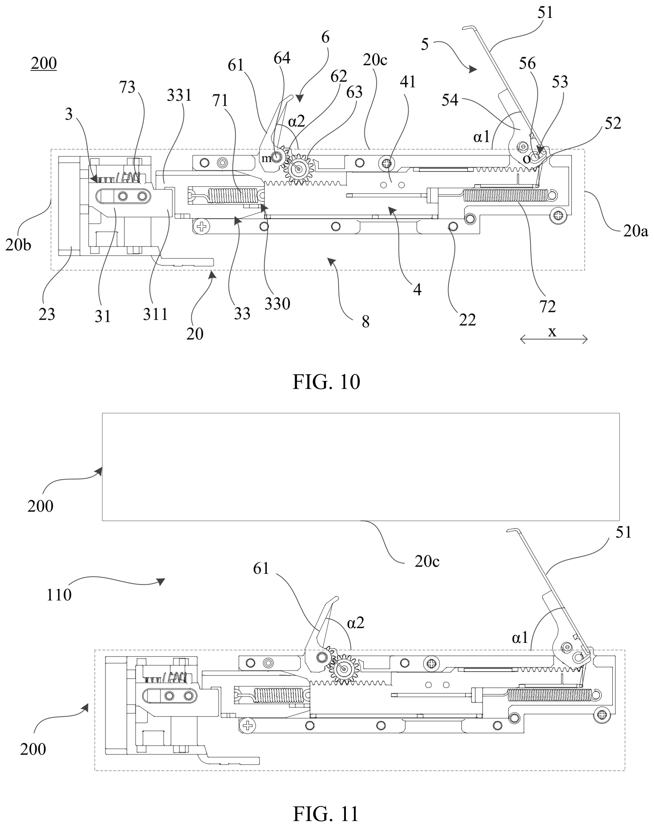

Refer to FIG. 7a to FIG. 11. FIG. 7a is a diagram of a three-dimensional structure of a communication board according to an embodiment of this application, where a backflow prevention plate is in a closed state. FIG. 7b is a diagram of a three-dimensional structure of a communication board according to an embodiment of this application, where a backflow prevention plate is in an open state. FIG. 7c is a diagram of a three-dimensional structure of a communication board from another angle according to an embodiment of this application, where a backflow prevention plate is in a closed state. FIG. 7d is a diagram of a three-dimensional structure of a communication board from another angle according to an embodiment of this application, where a backflow prevention plate is in an open state. FIG. 8a is a diagram of an exploded structure of a communication board according to an embodiment of this application. FIG. 8b is a partially enlarged view of a part E in FIG. 8a. FIG. 9 is a diagram of a planar structure of a communication board according to an embodiment of this application, where a first trigger component is at a non-trigger position, a transmission component is at a first position, and a backflow prevention plate is in a closed state. FIG. 10 is a diagram of a planar structure of a communication board according to an embodiment of this application, where a first trigger component is at a trigger position, a transmission component is at a second position, and a backflow prevention plate is in an open state. FIG. 11 is a diagram of a fitting relationship between the communication board in FIG. 10 and a neighboring slot.

As shown in FIG. 7a to FIG. 11, with reference to FIG. 5c for understanding, the communication board 200 includes a housing 20, a first trigger component 3, a transmission component 4, and a backflow prevention component 5.

The housing 20 of the communication board 200 has a top portion 20a and a bottom portion 20b that are opposite to each other, and a side wall 20c connected between the top portion 20a and the bottom portion 20b, and a mounting cavity 8 is surrounded by the top portion 20a, the bottom portion 20b, and the side wall 20c of the housing 20. It should be noted that specific structures of the top portion 20a, the bottom portion 20b, and the side wall 20c are not limited. In an example, the top portion 20a may be of a hollowed-out structure.

The first trigger component 3 is mounted in the housing 20, and at least a partial structure is disposed in the mounting cavity 8. The first trigger component 3 is movable relative to the housing 20 during insertion and removal of the communication board 200 in the slot 11, for the first trigger component 3 to switch between a trigger position and a non-trigger position relative to the housing 20. The first trigger component 3 may be entirely located inside the mounting cavity 8. Alternatively, one part of the structure is located inside the mounting cavity 8, and the other part is located outside the mounting cavity 8. In addition, the first trigger component 3 may be mounted at any position of the housing 20. In an implementation, the first trigger component 3 is close to the bottom portion 20b of the housing 20. The first trigger component 3 may be directly mounted on the housing 20, or may be indirectly mounted on the housing 20 by using another structural component. This is not limited in this application.

Further, the transmission component 4 is mounted in the mounting cavity 8 and is connected to the first trigger component 3, and the transmission component 4 is movable relative to the housing 20 in a first direction x when being driven by the first trigger component 3, for the transmission component 4 to switch between a first position and a second position relative to the housing 20. The first direction x may be any direction. In an implementation, the first direction x is parallel to the second direction y. A person skilled in the art may understand that a manner of mounting the transmission component 4 in the mounting cavity 8 is not limited. In an implementation, a base 22 is further disposed in the mounting cavity 8, the base 22 is fastened to the housing 20, and the transmission component 4 is slidably mounted on the base 22. Through the base 22, the mounting of the transmission component 4 in the mounting cavity 8 and the movement of the transmission component 4 relative to the housing 20 in the first direction x can be implemented. The base 22 and the housing 20 may be of an integrated structure or may be of separate structures. This is not limited in this application.

Further, the backflow prevention component 5 is connected to the transmission component 4 and is located on a side that is of the first trigger component 3 and that is away from the bottom portion 20b of the housing 20. The backflow prevention component 5 includes a backflow prevention plate 51 disposed on an outer side of the housing 20 (that is, an outer side of the mounting cavity 8). The backflow prevention plate 51 is rotatable relative to the housing 20 when being driven by the transmission component 4, for the backflow prevention plate 51 to switch between a closed state and an open state.

When the backflow prevention plate 51 is in the closed state (with reference to FIG. 9), the backflow prevention plate 51 is attached to the side wall 20c of the housing 20, and the transmission component 4 is located at the first position. The backflow prevention plate 51 may be directly attached to the side wall 20c of the housing 20, or may be indirectly attached to the side wall 20c of the housing 20. For example, some other structural components may be disposed between the backflow prevention plate 51 and the side wall 20c of the housing 20. This is not limited in this application. A person skilled in the art may understand that, that the backflow prevention plate 51 is attached to the side wall 20c of the housing 20 indicates that the backflow prevention plate 51 is closed relative to the side wall 20c of the housing 20, but does not indicate that the backflow prevention plate 51 has to be closely attached to the side wall 20c of the housing 20, and there may be a gap between the backflow prevention plate 51 and the side wall 20c of the housing 20.

When the backflow prevention plate 51 is in the open state (with reference to FIG. 10 and FIG. 11), the backflow prevention plate 51 is open relative to the side wall 20c of the housing 20, and an included angle α1 between the backflow prevention plate 51 and the side wall 20c of the housing 20 is an acute angle at which an opening faces the bottom portion 20b of the housing 20 (or this may be understood as that an included angle α1 between the backflow prevention plate 51 and the side wall 20c of the housing 20 is an acute angle at which an opening faces the first trigger component 3), and the transmission component 4 is located at the second position. Alternatively, it may be understood that the included angle α1 is an angle formed when the backflow prevention plate 51 in the closed state in FIG. 9 rotates clockwise to the position in FIG. 10. When the communication board 200 is located in the slot 11 of the communication device 100, back-flowing air is blown from the bottom portion 20b of the housing 20 to the top portion 20a in a direction from left to right in FIG. 10, that is, an air direction directly faces the opening between the backflow prevention plate 51 and the side wall 20c of the housing 20.

A person skilled in the art may understand that the magnitude of the included angle α1 is not limited and may be designed based on a structure of the communication device 100. As shown in FIG. 11, in an implementation, when the backflow prevention plate 51 is in the open state, the backflow prevention plate 51 can seal a slot 11 adjacent to the communication board 200. Alternatively, it may be understood that an angle at which the backflow prevention plate 51 is open can help seal the neighboring vacant slot 110, to prevent back-flowing air from entering the communication device 100 through the vacant slot 110.

As shown in FIG. 7a to FIG. 11, further, when the first trigger component 3 is located at the non-trigger position, the transmission component 4 is located at the first position, and the backflow prevention plate 51 is in the closed state. When the first trigger component 3 switches from the non-trigger position to the trigger position, the transmission component 4 is movable from the first position to the second position when being driven by the first trigger component 3, to drive the backflow prevention plate 51 to move from the closed state to the open state.

Alternatively, it may be understood that, when the transmission component 4 moves relative to the housing 20 from the first position to the second position, the backflow prevention plate 51 is driven to rotate from the closed state in which the backflow prevention plate 51 is attached to the side wall 20c of the housing 20 to the open state in which the backflow prevention plate 51 is open relative to the side wall 20c of the housing 20. In addition, the movement of the transmission component 4 from the first position to the second position may be triggered by the first trigger component 3. For example, in the process in which the communication board C is inserted into the vacant slot 110 in FIG. 6b, the first trigger component 3 of the communication board C moves from the non-trigger position to the trigger position and drives the transmission component 4 to move in the first direction x from the first position to the second position, and when being driven by the transmission component 4, the backflow prevention plate 51 of the communication board C rotates relative to the housing 20 to open and switch from the closed state to the open state.

According to the communication board 200 provided in this application, the backflow prevention plate 51 can switch between the open state and the closed state. The backflow prevention plate 51 in the open state may be configured to seal a neighboring vacant slot 110 in the communication device 100. In addition, the acute angle at which the opening faces the bottom portion 20b of the housing 20 is formed between the backflow prevention plate 51 and the side wall 20c of the housing 20 of the communication board 200, and back-flowing air in the communication device 100 usually flows from the bottom portion 20b of the housing 20 to the top portion 20a of the housing 20, that is, flows directly toward the opening between the backflow prevention plate 51 and the side wall 20c of the housing 20. Therefore, pressure of the back-flowing air on the backflow prevention plate 51 causes the backflow prevention plate 51 to have a tendency to move in an open direction instead of a closed direction, thereby avoiding a phenomenon that the backflow prevention gap d becomes larger due to the backflow prevention plate 51 closed under an action of a back-flowing air force. This better resolves a problem that the back-flowing air affects heat dissipation of the communication device 100. Moreover, the design of a rotatable connection structure between the backflow prevention plate 51 and the housing 20 is decoupled from the magnitude of the back-flowing air force, thereby improving applicability of the communication board 200.

According to another aspect, because the rotatable connection structure between the backflow prevention plate 51 and the housing 20 does not need to be designed based on an air force, the magnitude of a trigger force of the trigger component is also decoupled from the air force. Therefore, a phenomenon that the trigger component in operation deforms due to a large tensile force can be reduced, and a problem that a dead point of a friction force is reached due to a large friction force between the trigger component and the housing 20 is avoided, improving smoothness of system operation, and reducing a risk of getting stuck.

Therefore, in the communication board 200 provided in this application, the operation of the backflow prevention plate 51 is not affected by a back-flowing air force, and the backflow prevention gap d does not become larger with the increase of the air force, resulting in strong applicability of the communication board 200. In this way, a problem that back-flowing air affects heat dissipation of the communication device 100 can be better resolved, and components in the communication board 200 operate smoothly.

A person skilled in the art may understand that, during the movement of the transmission component 4 and the backflow prevention plate 51 that are linked, specific movement paths of the transmission component 4 and the backflow prevention plate 51 are not limited. In an implementation, an end that is of the backflow prevention plate 51 and that is close to the top portion 20a of the housing 20 is rotatably connected to the housing 20 around a first axis o, where the first axis o is perpendicular to the first direction x. The backflow prevention plate 51 may be directly rotatably connected to the housing 20, or may be indirectly rotatably connected to the housing 20. For example, another rotatable connection structure is disposed between the backflow prevention plate 51 and the housing 20.

Further, when the backflow prevention plate 51 switches from the closed state to the open state, the transmission component 4 is movable, toward the bottom portion 20b of the housing 20 in the first direction x, from the first position to the second position, and drives the backflow prevention plate 51 to rotate around the first axis o in a direction away from the side wall 20c of the housing 20, for the backflow prevention plate 51 to move to the open state.

Alternatively, it may be understood that, using an end that is of the backflow prevention plate 51 and that is close to the top portion 20a of the housing 20 as an axis center, the backflow prevention plate 51 rotates relative to the housing 20 around an axis perpendicular to the first direction x. Based on this design, the entire backflow prevention plate 51 can open relative to the side wall 20c of the housing 20, resulting in high rotation efficiency. In addition, when the transmission component 4 moves from the first position to the second position, the movement in the first direction x from a position close to the top portion 20a of the housing 20 to the bottom portion 20b of the housing 20 can easily achieve linkage effect of the transmission component 4 on the backflow prevention plate 51. In another alternative implementation, the transmission component 4 and the backflow prevention plate 51 may move along another path. For example, the backflow prevention plate 51 may alternatively be rotatably connected to the housing 20 at any position in an extension direction of the backflow prevention plate 51, and the first axis o may alternatively not be perpendicular to the first direction x, or the transmission component 4 may alternatively move toward the top portion 20a of the housing 20 when switching from the first position to the second position, or the like. This is not limited in this application.

A person skilled in the art may understand that, when the first trigger component 3 switches between the trigger position and the non-trigger position, a manner of the movement of the first trigger component 3 relative to the housing 20 may be linear movement, curvilinear movement, rotation, or the like. This is not limited in this application. In addition, when the first trigger component 3 moves relative to the housing 20 along a straight line, a movement direction of the first trigger component 3 may be any direction. In an implementation, when the first trigger component 3 switches between the trigger position and the non-trigger position, the first trigger component 3 moves relative to the housing 20 in the first direction x.

A person skilled in the art may understand that a specific trigger condition needs to be met for the first trigger component 3 to switch from the non-trigger position to the trigger position. For example, the first trigger component 3 is in contact with the chassis 1 or another structural component of the communication device 100. A manner of triggering the first trigger component 3 is not limited in this application. The following describes a triggering manner and an operating principle of the first trigger component 3 by using an example with reference to the accompanying drawings.

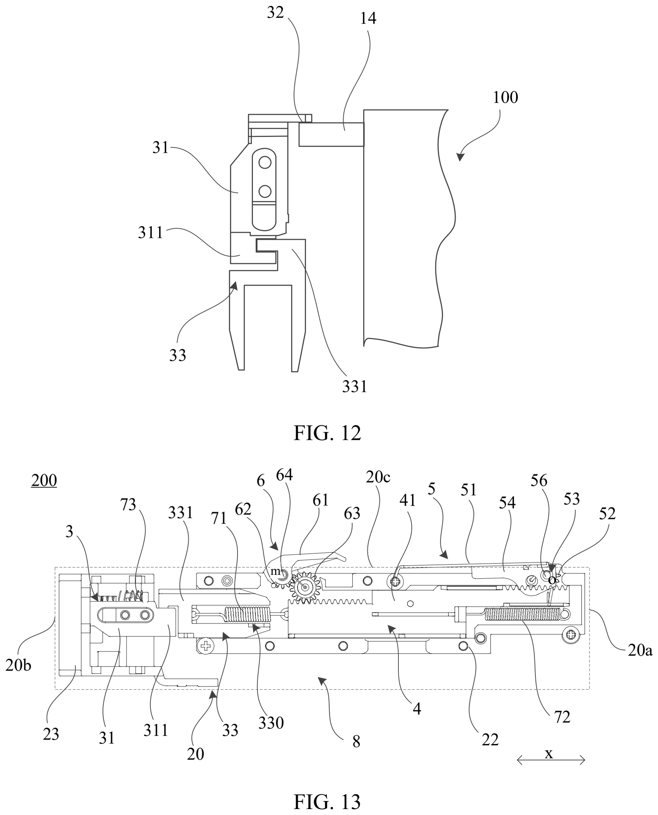

FIG. 12 is a diagram of a fitting relationship between a communication device and a trigger component in a communication board according to an embodiment of this application.

As shown in FIG. 12, with reference to FIG. 2 and FIG. 7a to FIG. 11 for understanding, in an implementation, the first trigger component 3 includes a first trigger rod 31, an opening 21 for the first trigger rod 31 to extend out is provided on the housing 20, the first trigger rod 31 is slidably connected to the housing 20, a first trigger portion 32 is disposed at an end that extends out of the mounting cavity 8, and in a process of inserting the communication board 200 into the slot 11, the first trigger portion 32 is configured to abut against a structural component or another communication board 200 on the communication device 100, to drive the first trigger rod 31 to move relative to the housing 20 from the non-trigger position to the trigger position. Alternatively, it may be understood that, in a process of inserting the communication board 200 into the slot 11, a structural component or another communication board 200 on the communication device 100 abuts against the first trigger portion 32, to prevent the first trigger component 3 from continuing to move in a direction in which the communication board 200 is inserted. Because the first trigger rod 31 and the housing 20 can slide relative to each other, the housing 20 continues to move in the slot 11. In this case, the first trigger rod 31 and the housing 20 move relative to each other, and the first trigger component 3 switches from the non-trigger position to the trigger position.

A specific position of the opening 21 is not limited, for example, may be on the bottom portion 20b or the side wall 20c of the housing 20. In an implementation, the opening 21 is located at a position that is on the side wall 20c of the housing 20 and that is close to the bottom portion 20b, and the first trigger portion 32 may move in the opening 21 when the first trigger rod 31 slides relative to the housing 20.

A person skilled in the art may understand that a structure that abuts against the first trigger portion 32 may be any structural component on the communication device 100 or any part on another communication board 200. In an implementation, a plurality of mold strips 14 are disposed on the chassis 1 of the communication device 100. In a process of inserting the communication board 200 into the slot 11, the first trigger portion 32 abuts against the mold strip 14, to drive the first trigger rod 31 to move relative to the housing 20. A quantity and positions of the mold strips 14 are not limited. For example, the quantity of the mold strips 14 corresponds to a quantity of the slots 11 in the communication device 100, and the mold strips 14 are distributed on one side or two sides of the slots 11. This is not limited in this application.

As shown in FIG. 7a to FIG. 11, in an implementation, to facilitate the assembly of the first trigger rod 31, an assembly component 23 is further disposed in the mounting cavity 8. The assembly component 23 is fastened to the bottom portion 20b of the housing 20, and a sliding slot for a first connecting rod to slide is provided inside the assembly component 23. The first trigger rod 31 is slidably mounted in the sliding slot. A person skilled in the art may understand that a specific structure of the assembly component 23 is not limited. In addition, the assembly component 23 may be disposed separately or may be designed as an integrated structure with the housing 20. This is not limited in this application.

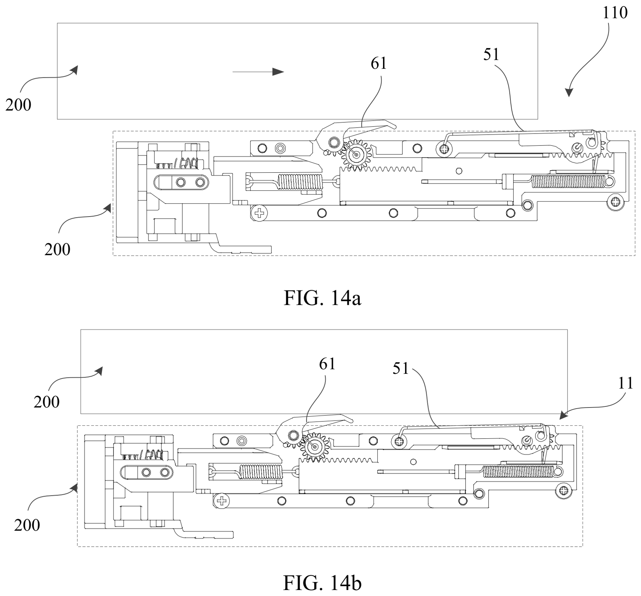

Refer to FIG. 13 to FIG. 14b. FIG. 13 is a diagram of a planar structure of a communication board according to an embodiment of this application, where a first trigger component is at a trigger position, a transmission component is at a first position, and a backflow prevention plate is in a closed state. FIG. 14a and FIG. 14b are diagrams of a fitting relationship between the communication board in FIG. 13 and a communication board in a neighboring slot.

As shown in FIG. 9 to FIG. 14b, in an implementation, the communication board 200 further includes a second trigger component 6, and the second trigger component 6 is connected to the transmission component 4 and includes a second trigger rod 61 disposed on the outer side of the housing 20. The second trigger rod 61 is rotatable relative to the housing 20 and drives the transmission component 4 to move in the first direction x, for the backflow prevention plate 51 to switch between the open state and the closed state. Alternatively, it may be understood that, through the rotation of the second trigger rod 61 relative to the housing 20, the transmission component 4 can be driven to move, and the backflow prevention plate 51 can be driven to rotate relative to the housing 20. When the communication board 200 is located in the slot 11, the second trigger component 6 can trigger the backflow prevention plate 51 to return to the closed state from the open state. A linkage manner of the second trigger component 6 and the transmission component 4 is not limited.

The second trigger rod 61 may be directly rotatably connected to the housing 20, or may be indirectly rotatably connected to the housing 20. For example, a rotatable connecting component is disposed between the second trigger rod 61 and the housing 20. A specific structure of the second trigger rod 61 is not limited. For example, the second trigger rod 61 may be of a rod structure, or may be of a bar structure or a plate structure.

In an implementation, an end that is of the second trigger rod 61 and that is close to the bottom portion 20b of the housing 20 is rotatably connected to the housing 20 around a second axis m, and the second trigger rod 61 and the backflow prevention plate 51 are movable toward each other or opposite to each other through movement of the transmission component 4 in the first direction x. The second axis m is perpendicular to the first direction x. In another alternative implementation, the second axis m may not be perpendicular to the first direction x.

Further, when the backflow prevention plate 51 is in the closed state, the second trigger rod 61 is attached to the side wall 20c of the housing 20. A person skilled in the art may understand that, that the second trigger rod 61 is attached to the side wall 20c of the housing 20 indicates that the second trigger rod 61 is closed relative to the side wall 20c of the housing 20, but does not indicate that the second trigger rod 61 has to be closely attached to the side wall 20c of the housing 20, and there may be a gap between the second trigger rod 61 and the side wall 20c of the housing 20. When the backflow prevention plate 51 is in the open state, the second trigger rod 61 is open relative to the side wall 20c of the housing 20, and an included angle α2 between the second trigger rod 61 and the side wall 20c of the housing 20 is an acute angle at which an opening 21 faces the top portion 20a of the housing 20. When the second trigger rod 61 that is open relative to the side wall 20c of the housing 20 rotates around the second axis m in a direction close to the side wall 20c of the housing 20, the transmission component 4 is movable from the second position to the first position, to drive the backflow prevention plate 51 to move from the open state to the closed state, for example, switch from the state shown in FIG. 10 to the state shown in FIG. 13.

Alternatively, it may be understood that the transmission component 4, the second trigger component 6, and the backflow prevention component 5 are linked to each other. The movement of the transmission component 4 in the first direction x (for example, the first trigger component 3 can drive the transmission component 4 to move relative to the housing 20 in the first direction x) can drive the second trigger rod 61 and the backflow prevention plate 51 to simultaneously open or close. The open or closed backflow prevention plate 51 can drive, by the transmission component 4, the second trigger rod 61 to simultaneously open or close. The open or closed second trigger rod 61 can also drive, by the transmission component 4, the backflow prevention plate 51 to simultaneously open or close. In addition, when both the second trigger rod 61 and the backflow prevention plate 51 are open relative to the housing 20, the included angle α1 is opposite to the included angle α2.

Based on this structure, when any communication board 200 is inserted into the slot 11, the backflow prevention plate 51 of a neighboring communication board 200 can be driven to close automatically. For example, when the communication board C in FIG. 6a is inserted into the slot 11, the backflow prevention plate 51 of the communication board D on the right side closes automatically. The following specifically describes an operation principle with reference to the accompanying drawings.

As shown in FIG. 11, when a communication board 200 is located in a slot 11 of the communication device 100, and a slot 11 on a neighboring side is a vacant slot 110, the backflow prevention plate 51 is in the open state, and the second trigger rod 61 is open relative to the side wall 20c of the housing 20. As shown in FIG. 14a and FIG. 14b, when another communication board 200 is inserted into the vacant slot 110 adjacent to the communication board 200, the inserted communication board 200 abuts against the second trigger rod 61 of the communication board 200, and applies pressure to the second trigger rod 61 while sliding along a side that is of the second trigger rod 61 and that faces away from the housing 20, so that the second trigger rod 61 rotates clockwise in FIG. 11 to a position at which the second trigger rod 61 is closed relative to the side wall 20c of the housing 20 in FIG. 14b. In addition, the backflow prevention plate 51 rotates to the closed state through the linkage with the transmission component 4, so that the neighboring communication board 200 can be smoothly inserted into the slot.

A person skilled in the art may understand that the first trigger component 3, the transmission component 4, and the second trigger component 6 together form a linkage group, and the backflow prevention plate 51 is controlled, based on a linkage relationship between the components in the linkage group, to open or close. A quantity of linkage groups in the communication board 200 is not limited. As shown in FIG. 7a to FIG. 8a, in an implementation, the top portion 20a and the bottom portion 20b of the housing 20 are opposite to each other in a width direction 12 of the communication board, the side wall 20c of the housing 20 includes two side walls opposite to each other in a length direction 11 of the communication board and two side walls opposite to each other in a thickness direction 13 of the communication board, the backflow prevention plate 51 is disposed on an outer side of any one of the two side walls opposite to each other in the thickness direction l3 of the communication board, and the backflow prevention plate 51 extends to two ends of the housing 20 in the length direction 11 of the communication board. Two linkage groups are disposed in the communication board 200, and the two linkage groups are separately disposed at two ends of the backflow prevention plate 51 in an extension direction of the backflow prevention plate 51 (that is, the length direction 11 of the communication device), for uniform force bearing of the backflow prevention plate 51. The length direction 11 of the communication device is perpendicular to the first direction x, the thickness direction l3 of the communication device may be perpendicular to the first direction, and the width direction l2 of the communication board corresponds to a height direction of the communication device 100 (or may be understood as that the width direction l2 of the communication board is parallel to the height direction of the communication device 100). A person skilled in the art may understand that a structure of the side wall is not limited, and the foregoing solution is merely an example.

To more clearly indicate an operation state of the communication board 200 provided in embodiments of this application in each scenario, the following summarizes positions and states of components inside the communication board 200 in different scenarios. For details, refer to Table 1.

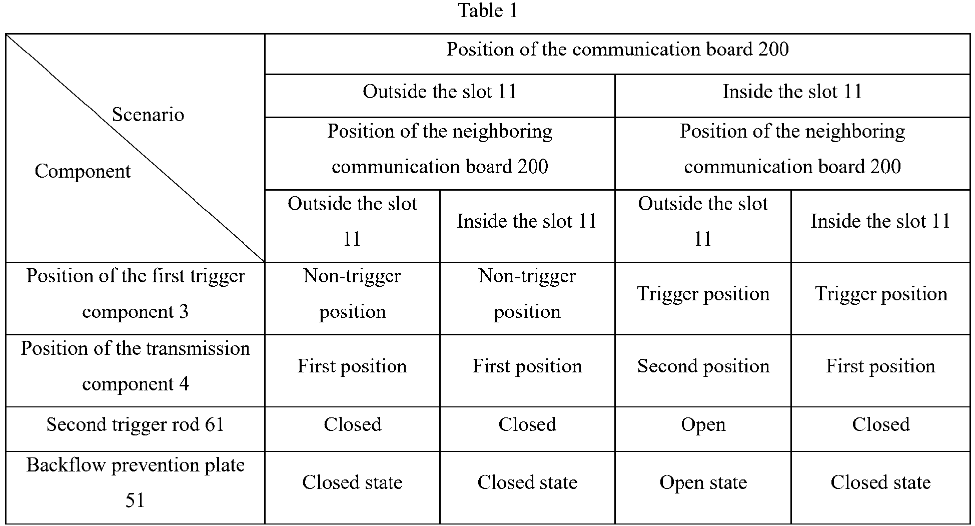

As described above, when the communication board 200 is located in the slot 11, the first trigger component 3 is at the trigger position, and the first trigger component 3 at the trigger position can drive the transmission component 4 to move toward the second position. In this case, if the backflow prevention plate 51 is driven through the rotation of the second trigger rod 61 to close, the transmission component 4 needs to be driven through the rotation of the second trigger rod 61 to return to the first position, and the first trigger component 3 remains at the trigger position relative to the housing 20. Therefore, it is necessary to design a connection manner between the first trigger component 3 and the transmission component 4, to meet both a scenario in which "when the communication board 200 is inserted into the slot 11, the transmission component 4 is driven by the first trigger component 3 to switch from the first position to the second position" and a scenario in which "when the communication board 200 is located in the slot 11, the transmission component 4 is driven through the rotation of the second trigger rod 61 to return to the first position". A person skilled in the art may understand that a structure that can meet the foregoing scenarios is not unique. The following describes a connection manner between the first trigger component 3 and the transmission component 4 by using an example with reference to the accompanying drawings.

As shown in FIG. 3a to FIG. 14b, in an implementation, the first trigger component 3 and the transmission component 4 are elastically connected by a first elastic component 71, for the first trigger component 3 and the transmission component 4 to move relative to each other in the first direction x. When the first trigger assembly 3 is located at the non-trigger position and the transmission component 4 is located at the first position (with reference to FIG. 9), or when the first trigger component 3 is located at the trigger position and the transmission component 4 is located at the second position (with reference to FIG. 10), the transmission component 4 and the first trigger component 3 abut against each other. When the first trigger component 3 is located at the trigger position and the transmission component 4 is located at the first position (with reference to FIG. 13 to FIG. 14b), the transmission component 4 and the first trigger component 3 are separated from each other. Under an action of an elastic force of the first elastic component 71, the transmission component 4 is capable of remaining at a position at which the transmission component 4 and the first trigger component 3 abut against each other, or is capable of returning, from a position at which the transmission component 4 and the first trigger component 3 are separated from each other, to a position at which the transmission component 4 and the first trigger component 3 abut against each other.

Alternatively, it may be understood that, in a case that a neighboring slot is a vacant slot 110, during insertion of a communication board 200 in the vacant slot 110, the transmission component 4, when being driven by the first elastic component 71, remains in a state in which the transmission component 4 and the first trigger component 3 abut against each other. In this case, when the first trigger component 3 moves from the non-trigger position to the trigger position, the transmission component 4 is driven to move from the first position to the second position, and remains at the second position. When the communication board 200 is located in the slot 11 and the backflow prevention plate 51 is in the open state, another communication board is inserted into a neighboring vacant slot 110, and the second trigger rod 61 of the communication board 200 rotates in a closed direction under an action of an external force of the inserted communication board, to drive the transmission component 4 to move toward the first position. In this case, the transmission component 4 overcomes a tensile force of the first elastic component 71 to be separated from the first trigger component 3.

The transmission component 4 may abut against any position of the first trigger component 3. In an implementation, the first trigger component 3 further includes a connecting component 33. One end of the connecting component 33 is detachably fastened to the first trigger rod 31, and the other end may abut against or be separated from the transmission component 4. One end of the first elastic component 71 is connected to the transmission component 4, and the other end is connected to the connecting component 33, for the connecting component 33 fastened to the first trigger rod 31 to be elastically connected to the transmission component 4 by the first elastic component 71.

Based on this structure, the first trigger component 3 and the transmission component 4 are detachable from each other, facilitating component of the communication device 100. For example, two ends of the first elastic component 71 may be first connected to the connecting component 33 and the transmission component 4 respectively, then the first trigger portion 32 passes through the opening 21 of the housing 20, and then the first trigger rod 31 is fastened to the connecting component 33. A connection manner of the first trigger rod 31 and the connecting component 33 is not limited. In an implementation, a hook 311 is disposed at an end that is of the first trigger rod 31 and that is close to the connecting component 33, and a hook 331 is disposed at an end that is of the connecting component 33 and that is close to the first trigger rod 31. The connecting component 33 is detachably fastened to the first trigger rod 31 by snap-fitting of the hook 311 and the hook 331. A specific structure of the connecting component 33 is not limited. In an implementation, a cavity 330 is provided at an end that is of the connecting component 33 and that is close to the transmission component 4, and the first elastic component 71 is mounted in the cavity 330, to protect the first elastic component 71 and prevent the first elastic component 71 from entangling another structural component.

As described above, after the communication board 200 is removed from the slot 11, the backflow prevention plate 51 can close automatically. For example, in FIG. 6a, after the communication board C is removed from the slot 11, the backflow prevention plate 51 of the communication board C automatically switches from the open state to the closed state. To implement this function, a connection manner of the transmission component 4, the first trigger component 3, and the housing 20 is designed, so that the transmission component 4 of the communication board 200 can automatically return to the first position from the second position after the communication board 200 is removed. A person skilled in the art may understand that a structure that can meet the foregoing scenario is not unique. The following describes a connection structure between the transmission component 4, the first trigger component 3, and the housing 20 by using an example with reference to the accompanying drawings.

As shown in FIG. 7a to FIG. 14a, in an implementation, an end that is of the transmission component 4 and that is close to the top portion 20a of the housing 20 is elastically connected to the housing 20 by a second elastic component 72, and the first trigger component 3 is elastically connected to the housing 20 by a third elastic component 73. A person skilled in the art may understand that the transmission component 4 may be directly elastically connected to the housing 20 by the second elastic component 72, or may be indirectly elastically connected to the housing 20, for example, may be elastically connected to the housing 20 by a base. Similarly, the first trigger component 3 may be directly elastically connected to the housing 20 by the third elastic component 73, or may be indirectly elastically connected to the housing 20, for example, may be elastically connected to the housing 20 by a base 22. This is not limited in this application.

Under a combined action of an elastic force of the second elastic component 72 and an elastic force of the third elastic component 73, the first trigger component 3 is capable of remaining at the non-trigger position and the transmission component 4 remains at the first position, or the first trigger component 3 is capable of returning to the non-trigger position from the trigger position and the transmission component 4 returns to the first position from the second position (with reference to FIG. 9). Alternatively, it may be understood that, when the communication board 200 is inserted into the slot 11 or is removed from the slot 11, an elastic force (for example, a tensile force) of the second elastic component 72 drives the transmission component 4 to return to the first position. At the same time, an elastic force (for example, a pushing force) of the third elastic component 73 drives the first trigger rod 31 to slide relative to the housing 20, so that the first trigger component 3 returns to the non-trigger position.

Further, under a combined action of the elastic force of the first elastic component 71 and the elastic force of the second elastic component 72, the transmission component 4 is capable of remaining at a position at which the transmission component 4 and the first trigger component 3 abut against each other, or is capable of returning, from a position at which the transmission component 4 and the first trigger component 3 are separated from each other, to a position at which the transmission component 4 and the first trigger component 3 abut against each other (with reference to FIG. 10). Alternatively, it may be understood that, when the communication board 200 is inserted into the slot 11, an elastic force (for example, a tensile force) of the first elastic component 71 can overcome an elastic force (for example, a pulling force) of the second elastic component 72, so that the transmission component 4 can move from the first position to the second position when being driven by the first trigger component 3. In other words, a minimum elastic force generated when the first elastic component 71 deforms is greater than a maximum elastic force generated when the second elastic component 72 deforms.

A person skilled in the art may understand that materials and types of the first elastic component 71, the second elastic component 72, and the third elastic component 73 are not limited. For example, any elastic component may be a spring, a sponge, or the like. In an implementation, the first elastic component 71, the second elastic component 72, and the third elastic component 73 are all springs.

A person skilled in the art may understand that specific structures of the transmission component 4, the backflow prevention component 5, and the second trigger component 6 are not limited, and a linkage manner of the transmission component 4, the backflow prevention component 5, and the second trigger component 6 is not limited. The following describes structures that can be used for the transmission component 4, the backflow prevention component 5, and the second trigger component 6 by using an example with reference to the accompanying drawings.

As shown in FIG. 7a to FIG. 14b, in an implementation, the transmission component 4 includes a rack 41 that extends in the first direction x, the backflow prevention component 5 further includes a first gear 52 disposed at an end that is of the backflow prevention plate 51 and that is close to the top portion 20a of the housing 20, and the rack 41 is engaged with the first gear 52. When the backflow prevention plate 51 is inserted into the slot 11, the transmission component 4 moves in the first direction x from the first position to the second position, the rack 41 moves in the first direction x toward the bottom portion 20b of the housing 20 to drive the first gear 52 to rotate, and the backflow prevention plate 51 opens. Alternatively, it may be understood that the rack 41 in FIG. 9 moves from right to left to the position in FIG. 10, to drive the first gear 52 to rotate clockwise, so that the backflow prevention plate 51 switches from the closed state to the open state.

A person skilled in the art may understand that a connection manner of the first gear 52 and the backflow prevention plate 51 is not limited. For example, the first gear 52 and the backflow prevention plate 51 may be designed as an integrated structure, and an end of the backflow prevention plate 51 is directly processed into a gear shape. As shown in FIG. 7a to FIG. 14b, in an implementation, to reduce processing difficulty, a connecting plate 54 is disposed between the first gear 52 and the backflow prevention plate 51. During processing, the first gear 52 may be separately produced, and then the first gear 52 is mounted at an end of the backflow prevention plate 51 by using the connecting plate 54.

In an implementation, to mount the backflow prevention component 5 on the housing 20, a first connecting shaft 56 is further disposed in the communication board 200. The first connecting shaft 56 extends in a direction perpendicular to the first direction x, and sequentially passes through the housing 20, the base 22, the center of the first gear 52, and the connecting plate 54. The first gear 52 and the connecting plate 54 rotate around the first connecting shaft 56, to drive the backflow prevention plate 51 to rotate. Alternatively, it may be understood that a shaft center of the first connecting shaft 56 is the first axis o. In another alternative implementation, the backflow prevention component 5 may be mounted on the housing 20 by using another structure. This is not limited in this application.

As shown in FIG. 7a to FIG. 14b, in an implementation, the second trigger component 6 further includes a second gear 62 disposed at an end that is of the second trigger rod 61 and that is away from the top portion 20a of the housing 20, and a third gear 63 located between the second gear 62 and the rack 41, where the third gear 63 is engaged with the rack 41, and the second gear 62 is engaged with the third gear 63. A connection manner of the first gear 52 and the backflow prevention plate 51 is not limited. When the communication board 200 is located in the slot 11, and both the backflow prevention plate 51 and the second trigger rod 61 are open relative to the housing 20, the second trigger rod 61 rotates in a closed direction, the second gear 62 drives the third gear 63 to rotate, the third gear 63 drives the rack 41 to move from the second position to the first position, and the rack 41 drives the first gear 52 to rotate, so that the backflow prevention plate 51 moves in a closed direction. Alternatively, it may be understood that, in FIG. 10, the second trigger rod 61 rotates clockwise, the second gear 62 rotates clockwise at the same time to drive the third gear 63 to rotate counterclockwise, the rack 41 moves from left to right to drive the first gear 52 to rotate counterclockwise, the backflow prevention plate 51 rotates counterclockwise at the same time to close, and the communication board 200 switches to the state in FIG. 13.

It should be noted that movement processes of the components in the foregoing examples are reversible. The transmission component 4, the backflow prevention component 5, and the second trigger component 6 are linked to each other. When any component of the transmission component 4, the backflow prevention component 5, and the second trigger component 6 moves, other components can be driven to move. A person skilled in the art may understand that implementing the linkage of the transmission component 4, the backflow prevention component 5, and the second trigger component 6 through the engagement of the rack 41 and the gear is merely a feasible solution. During actual application, there may be another solution, for example, a linkage mechanism is used. Details are not listed in this application.

In an implementation, to mount the second trigger component 6 on the housing 20, a second connecting shaft 64 is further disposed in the communication board 200. The second connecting shaft 64 extends in a direction perpendicular to the first direction x, and passes through the housing 20, the base 22, the center of the second gear 62, and an end that is of the second trigger rod 61 and that is connected to the second gear 62. The second gear 62 rotates around the second connecting shaft 64, to drive the second trigger rod 61 to rotate. Alternatively, it may be understood that a shaft center of the second connecting shaft 64 is the second axis m. In another alternative implementation, the backflow prevention component 5 may be mounted on the housing 20 by using another structure. This is not limited in this application.

Refer to FIG. 5c to FIG. 6c again. In the communication board 200 provided in this application, after the backflow prevention plate 51 opens, the neighboring vacant slot 110 can be sealed. Therefore, a structure of the communication board 200 needs to be designed for the backflow prevention plate 51 in the open state to meet the following conditions: the backflow prevention gap d meets a heat dissipation requirement of a system chip, and spaced communication boards 200 are not stuck during insertion and removal (for example, if the backflow prevention plate 51 of the communication board D in FIG. 6c opens at an excessively large angle, the insertion of the communication board B into the slot 11 may be hindered because the communication board B touches an end portion of the backflow prevention plate 51 of the communication board D, and consequently the communication board B cannot be inserted smoothly). A size of the backflow prevention gap d is not limited, but a smaller size is better. For example, the size of the backflow prevention gap d may be 1 mm, 1.5 mm, 2 mm, or the like, or may reach 0 mm in an extreme case. The following describes a structure that can be used by using an example with reference to the accompanying drawings.

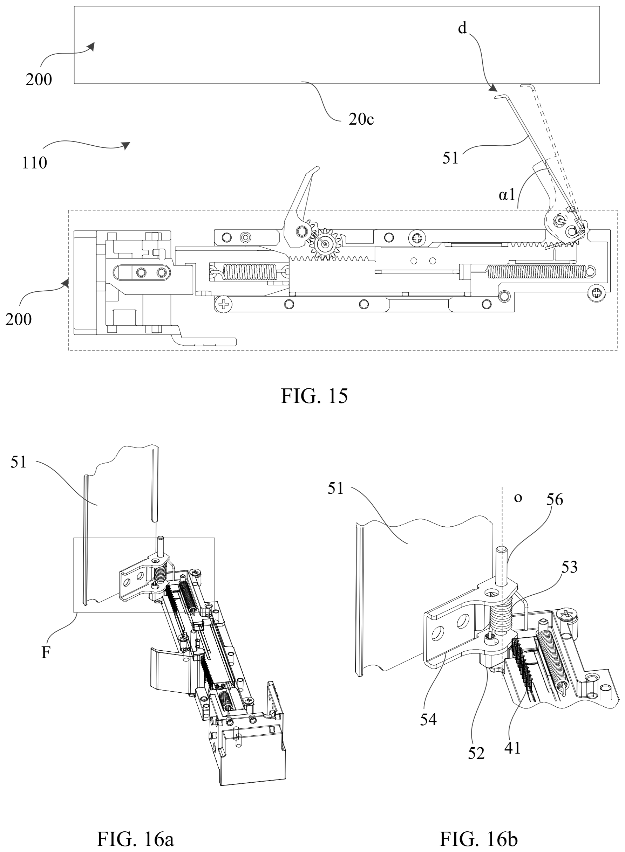

Refer to FIG. 15 to FIG. 16b. FIG. 15 is a diagram of a structure of a communication board according to an embodiment of this application, where a backflow prevention plate is rotatably connected to a first gear. FIG. 16a is a diagram of connections of a backflow prevention plate, a torsion spring, and a first gear in a communication board according to an embodiment of this application. FIG. 16b is a partially enlarged view of a part F in FIG. 16a.

As shown in FIG. 15, in an implementation, the backflow prevention plate 51 is rotatably connected to the first gear 52, and when the backflow prevention plate 51 is in the open state, the backflow prevention plate 51 is rotatable, under an action of an external force (for example, an air force) in a direction toward the top portion 20a of the housing 20, relative to the first gear 52 in a direction away from the side wall 20c of the housing 20. More visually, when the backflow prevention plate 51 in the open state in FIG. 15 is subjected to an external force provided by back-flowing air, the backflow prevention plate 51 further rotates clockwise to a dashed line position, and the included angle α1 increases. Based on this structure, back-flowing air provides help. This can not only ensure that spaced network boards are not stuck during insertion and removal, but also minimize the backflow prevention gap d. For example, the included angle α1 is designed to be a specific value. When the backflow prevention plate 51 is open and a back-flowing air force is small, there is a specific backflow prevention gap d between the backflow prevention plate 51 and the side wall 20c of the spaced network board. In this case, due to small back-flowing air, heat dissipation of the communication device 100 is not greatly affected, and the spaced communication board in the slot cannot be stuck during insertion and removal because the spaced communication board touches an end portion of the open backflow prevention plate 51. When the back-flowing air force increases, the backflow prevention plate 51 further rotates to open, and the backflow prevention gap d is reduced. In addition, a larger air force indicates a larger rotation angle of the backflow prevention plate 51. Finally, the backflow prevention plate 51 may be attached to the side wall 20c of the spaced communication board 200, so that the backflow prevention gap d is reduced to 0.

A rotatable connection manner of the backflow prevention plate 51 and the first gear 52 is not limited. For example, the rotatable connection may be implemented by using a torsion spring, a gear, a rotating shaft, or another structure.

As shown in FIG. 15 to FIG. 16b, in an implementation, the backflow prevention plate 51 is rotatably connected to the first gear 52 by a torsion spring 53. As a quantity of times of insertion and removal increases, the backflow prevention plate 51 may be partially loose or may not return in place. Consequently, when the backflow prevention plate 51 is in the closed state, there is still an opening angle between the backflow prevention plate 51 and the side wall 20c of the housing 20, hindering insertion and removal of a neighboring communication board. The torsion spring 53 is disposed between the backflow prevention plate 51 and the first gear 52. When the backflow prevention plate 51 is in the closed state, the backflow prevention plate 51 can be closely attached to the side wall 20c of the housing 20 under an action of a force of the torsion spring 53, avoiding a problem that the backflow prevention plate 51 does not return in place. When the backflow prevention plate 51 is in the open state and is subjected to a large air force, the torsion spring 53 is compressed, so that the backflow prevention plate 51 further opens, and the backflow prevention gap d is reduced.

A manner of mounting the torsion spring 53 is not limited. In an implementation, the torsion spring 53 is entirely sleeved outside the first connecting shaft 56, one end of the torsion spring 53 is connected to the first gear 52, and the other end is connected to the backflow prevention plate 51. A person skilled in the art may understand that manners of connecting two ends of the torsion spring 53 to the first gear 52 and the backflow prevention plate 51 are not limited. In an implementation, one end of the torsion spring 53 passes through the first gear 52, and the other end is fastened to the connecting plate 54 and is fastened to the backflow prevention plate 51 through the connecting plate 54.

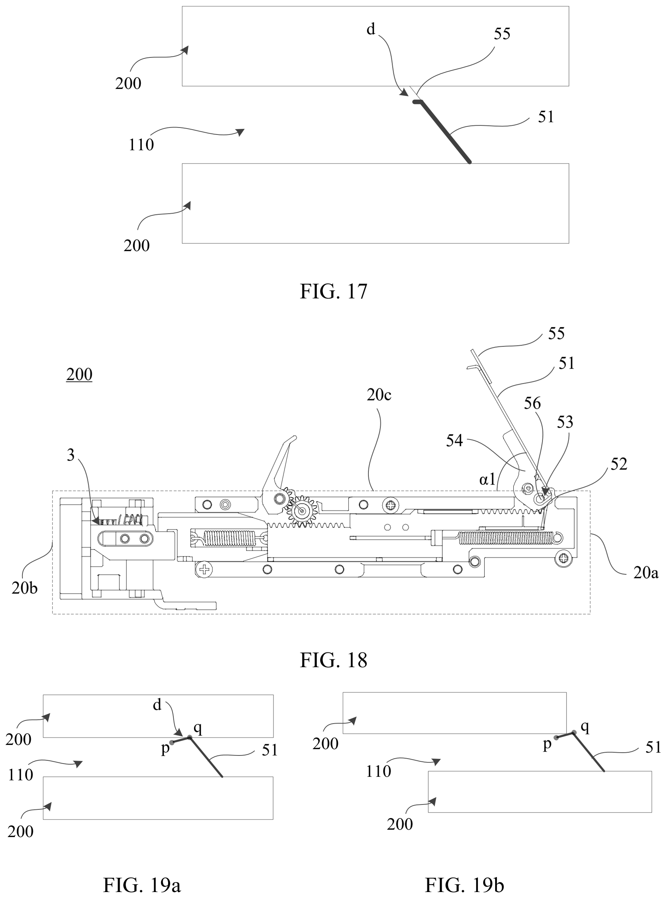

Refer to FIG. 17 and FIG. 18. FIG. 17 is a diagram of a principle of a communication board according to an embodiment of this application, where a flexible component is disposed at an end that is of a backflow prevention plate and that is away from a top portion of a housing. FIG. 18 is a diagram of a planar structure of a communication board according to an embodiment of this application, where a flexible component is disposed at an end that is of a backflow prevention plate and that is away from a top portion of a housing.

As shown in FIG. 17 and FIG. 18, in an implementation, a flexible component 55 is disposed at an end that is of the backflow prevention plate 51 and that is away from the top portion 20a of the housing 20. Under the action of a back-flowing air force, the flexible component 55 can extend in a direction facing away from the side wall 20c of the housing 20, to fill the backflow prevention gap d. This structure is simple and has low implementation costs.

A material of the flexible component 55 is not limited, for example, may be rubber, plastic, cotton and linen, or another material. In an implementation, the material of the flexible component 55 is silicone rubber. In another alternative implementation, the material of the flexible component 55 is a PC film (Polycarbonate, polycarbonate film).

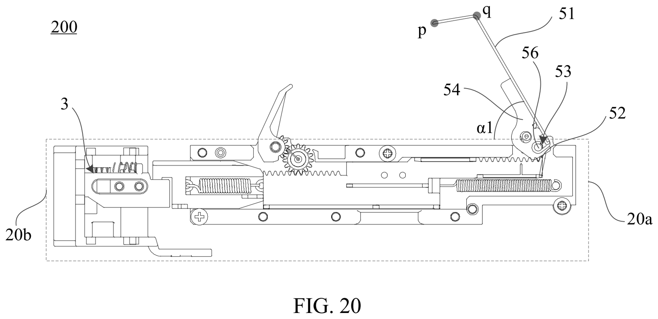

Refer to FIG. 19a to FIG. 20. FIG. 19a and FIG. 19b are diagrams of a principle of a communication board according to an embodiment of this application, where an end that is of a backflow prevention plate and that is away from a top portion of a housing is bent toward a side wall of the housing. FIG. 20 is a diagram of a planar structure of a communication board according to an embodiment of this application, where an end that is of a backflow prevention plate and that is away from a top portion of a housing is bent toward a side wall of the housing.

As shown in FIG. 19a to FIG. 20, in an implementation, an end that is of the backflow prevention plate 51 and that is away from the top portion 20a of the housing 20 is at least partially bent toward the side wall 20c of the housing 20, and when the backflow prevention plate 51 is in the open state, the end that is of the backflow prevention plate 51 and that is away from the top portion 20a of the housing 20 may be located in the slot 11 adjacent to the communication board 200. Alternatively, it may be understood that, when the communication board 200 is located in the slot, and the backflow prevention plate 51 of the communication board 200 is in the open state, an end (the point p in FIG. 19a and FIG. 19b) that is of the backflow prevention plate 51 and that is away from the top portion 20a of the housing 20 is located in a neighboring vacant slot 110, and does not enter a region in which a spaced slot 11 is located. Based on this structure, a large included angle α1 may be designed, so that a bending point (the point q in FIG. 19a) of the open backflow prevention plate 51 abuts against a communication board 200 in the spaced slot 11, and the backflow prevention gap d is reduced to 0. In addition, when the communication board is inserted into the spaced slot, the inserted communication board abuts against a point between the point p and the point q, and slides from this point in an extension direction of the backflow prevention plate 51, to continue to be inserted into the slot. Therefore, this structure can not only minimize the backflow prevention gap d, but also avoid stucking during insertion of the spaced communication board 200.

A person skilled in the art may understand that the foregoing structure is merely an example for description. During actual application, another solution may be used. Details are not listed in this application.

An embodiment of this application further provides a communication device. The communication device may be the communication device provided in FIG. 1 to FIG. 6c, or a communication device of any other structure. The communication device includes a chassis and a plurality of communication boards 200 provided in any one of the foregoing embodiments, where a plurality of slots are provided on the chassis, the plurality of slots and the plurality of communication boards 200 are in a one-to-one correspondence, each of the plurality of communication boards 200 is disposed in the corresponding slot in a pluggable manner, and the backflow prevention plate on the communication board 200 may be configured to seal the slot adjacent to the communication board 200 in the communication device, to prevent air for heat dissipation of the communication device from flowing back into the chassis to affect heat dissipation of the communication device.

In an implementation, after any one of the plurality of communication boards 200 is removed from the slot, a backflow prevention plate of the communication board 200 is in the closed state, and a backflow prevention plate of a communication board 200 adjacent to the communication board 200 in the communication device is switchable from the closed state to the open state.

It is clearly that a person skilled in the art can make various modifications and variations to this application without departing from the spirit and scope of this application. This application is intended to cover these modifications and variations of this application provided that they fall within the scope of the claims of this application and their equivalent technologies.

## Claims

1. A communication board for a communication device, wherein the communication board is disposed in a slot of the communication device in a pluggable manner, and comprises:
a housing, wherein the housing has a top portion and a bottom portion that are opposite to each other, and a side wall connected between the top portion and the bottom portion, and a mounting cavity is surrounded by the top portion, the bottom portion, and the side wall of the housing;
a first trigger component, wherein the first trigger component is mounted in the housing, and at least a partial structure is disposed in the mounting cavity; and the first trigger component is movable relative to the housing during insertion and removal of the communication board in the slot, for the first trigger component to switch between a trigger position and a non-trigger position relative to the housing;
a transmission component, wherein the transmission component is mounted in the mounting cavity and is connected to the first trigger component, and the transmission component is movable relative to the housing in a first direction when being driven by the first trigger component, for the transmission component to switch between a first position and a second position relative to the housing; and
a backflow prevention component, wherein the backflow prevention component is connected to the transmission component and is located on a side that is of the first trigger component and that is away from the bottom portion of the housing; and the backflow prevention component comprises a backflow prevention plate disposed on an outer side of the housing, and the backflow prevention plate is rotatable relative to the housing when being driven by the transmission component, for the backflow prevention plate to switch between a closed state and an open state, wherein
when the backflow prevention plate is in the closed state, the backflow prevention plate is attached to the side wall of the housing, and the transmission component is located at the first position; when the backflow prevention plate is in the open state, the backflow prevention plate is open relative to the side wall of the housing, an included angle between the backflow prevention plate and the side wall of the housing is an acute angle at which an opening faces the bottom portion of the housing, and the transmission component is located at the second position; and
when the first trigger component is located at the non-trigger position, the transmission component is located at the first position, and the backflow prevention plate is in the closed state; and when the first trigger component switches from the non-trigger position to the trigger position, the transmission component is movable from the first position to the second position when being driven by the first trigger component, to drive the backflow prevention plate to move from the closed state to the open state.

2. The communication board according to claim 1, wherein the backflow prevention plate is capable of sealing a slot adjacent to the communication board when the backflow prevention plate is in the open state.

3. The communication board according to claim 1, wherein an end that is of the backflow prevention plate and that is close to the top portion of the housing is rotatably connected to the housing around a first axis, wherein the first axis is perpendicular to the first direction; and
when the backflow prevention plate switches from the closed state to the open state, the transmission component is movable, toward the bottom portion of the housing in the first direction, from the first position to the second position, and drives the backflow prevention plate to rotate around the first axis in a direction away from the side wall of the housing, for the backflow prevention plate to move to the open state.

4. The communication board according to claim 1, wherein the communication board further comprises a second trigger component, and the second trigger component is connected to the transmission component and comprises a second trigger rod disposed on the outer side of the housing; and
the second trigger rod is rotatable relative to the housing and drives the transmission component to move in the first direction, for the backflow prevention plate to switch between the open state and the closed state.

5. The communication board according to claim 4, wherein an end that is of the second trigger rod and that is close to the bottom portion of the housing is rotatably connected to the housing around a second axis, and the second trigger rod and the backflow prevention plate are movable toward each other or opposite to each other through movement of the transmission component in the first direction, wherein the second axis is perpendicular to the first direction;
when the backflow prevention plate is in the closed state, the second trigger rod is attached to the side wall of the housing; when the backflow prevention plate is in the open state, the second trigger rod is open relative to the side wall of the housing, and an included angle between the second trigger rod and the side wall of the housing is an acute angle at which an opening faces the top portion of the housing; and
when the second trigger rod that is open relative to the side wall of the housing rotates around the second axis in a direction close to the side wall of the housing, the transmission component is movable from the second position to the first position, to drive the backflow prevention plate to move from the open state to the closed state.

6. The communication board according to claim 4, wherein the first trigger component and the transmission component are elastically connected by a first elastic component, for the first trigger component and the transmission component to move relative to each other in the first direction; and
when the first trigger component is located at the non-trigger position and the transmission component is located at the first position, or when the first trigger component is located at the trigger position and the transmission component is located at the second position, the transmission component and the first trigger component abut against each other; and when the first trigger component is located at the trigger position and the transmission component is located at the first position, the transmission component and the first trigger component are separated from each other, wherein
under an action of an elastic force of the first elastic component, the transmission component is capable of remaining at a position at which the transmission component and the first trigger component abut against each other, or is capable of returning, from a position at which the transmission component and the first trigger component are separated from each other, to a position at which the transmission component and the first trigger component abut against each other.

7. The communication board according to claim 6, wherein an end that is of the transmission component and that is close to the top portion of the housing is elastically connected to the housing by a second elastic component, and the first trigger component is elastically connected to the housing by a third elastic component;
under a combined action of an elastic force of the second elastic component and an elastic force of the third elastic component, the first trigger component is capable of remaining at the non-trigger position and the transmission component remains at the first position, or the first trigger component is capable of returning to the non-trigger position from the trigger position and the transmission component returns to the first position from the second position; and
under a combined action of the elastic force of the first elastic component and the elastic force of the second elastic component, the transmission component is capable of remaining at a position at which the transmission component and the first trigger component abut against each other, or is capable of returning, from a position at which the transmission component and the first trigger component are separated from each other, to a position at which the transmission component and the first trigger component abut against each other.

8. The communication board according to claim 6, wherein the first trigger component comprises a first trigger rod and a connecting component, an opening for the first trigger rod to extend out is provided on the housing, the first trigger rod is slidably connected to the housing, a first trigger portion is disposed at an end that extends out of the mounting cavity, and in a process of inserting the communication board into the slot, the first trigger portion is configured to abut against a structural component or another communication board on the communication device, to drive the first trigger rod to move relative to the housing from the non-trigger position to the trigger position; and
one end of the connecting component is detachably fastened to the first trigger rod, and the other end is capable of abutting against or is separable from the transmission component; and one end of the first elastic component is connected to the transmission component, and the other end is connected to the connecting component, for the connecting component fastened to the first trigger rod to be elastically connected to the transmission component by the first elastic component.

9. The communication board according to any one of claims 1 to 8, wherein the transmission component comprises a rack that extends in the first direction, the backflow prevention component further comprises a first gear disposed at an end that is of the backflow prevention plate and that is close to the top portion of the housing, and the rack is engaged with the first gear.

10. The communication board according to claim 9, wherein when the communication board comprises the second trigger component, the second trigger component further comprises a second gear disposed at an end that is of the second trigger rod and that is away from the top portion of the housing, and a third gear located between the second gear and the rack, wherein the third gear is engaged with the rack, and the second gear is engaged with the third gear.

11. The communication board according to claim 9, wherein the backflow prevention plate is rotatably connected to the first gear, and when the backflow prevention plate is in the open state, the backflow prevention plate is rotatable, under an action of an external force in a direction toward the top portion of the housing, relative to the first gear in a direction away from the side wall of the housing.

12. The communication board according to claim 11, wherein the backflow prevention plate is rotatably connected to the first gear by a torsion spring.

13. The communication board according to any one of claims 1 to 8, wherein a flexible component is disposed at an end that is of the backflow prevention plate and that is away from the top portion of the housing.

14. The communication board according to any one of claims 1 to 8, wherein an end that is of the backflow prevention plate and that is away from the top portion of the housing is at least partially bent toward the side wall of the housing, and when the backflow prevention plate is in the open state, the end that is of the backflow prevention plate and that is away from the top portion of the housing is capable of being located in the slot adjacent to the communication board.

15. A communication device, comprising a chassis and a plurality of communication boards according to any one of claims 1 to 14, wherein a plurality of slots are provided on the chassis, the plurality of slots and the plurality of communication boards are in a one-to-one correspondence, each of the plurality of communication boards is disposed in the corresponding slot in a pluggable manner, and the backflow prevention plate on the communication board is configured to seal the slot adjacent to the communication board in the communication device.

16. The communication device according to claim 15, wherein after any one of the plurality of communication boards is removed from the slot, a backflow prevention plate of the communication board is in the closed state, and a backflow prevention plate of a communication board adjacent to the communication board in the communication device is switchable from the closed state to the open state.
